# EUROPÄISCHE PATENTSCHRIFT

(11) **EP 3 204 463 B1**
(45) Veröffentlichungstag und Bekanntmachung des Hinweises auf die Patenterteilung: **17.04.2019**
(21) Anmeldenummer: 15778639.3
(22) Anmeldetag: 08.10.2015
(51) Int. Cl.: C09K 11/06, C09B 57/10, H01L 51/00, C07F 1/08, H01L 51/50

(54) **METALL-KOMPLEXE MIT TRIDENTATEN LIGANDEN FÜR OPTOELEKTRONISCHE ANWENDUNGEN**
METAL COMPLEXES WITH TRIDENTATE LIGANDS FOR OPTOELECTRONIC APPLICATIONS
COMPLEXES MÉTALLIQUES PRÉSENTANT DES LIGANDS TRIDENTATES POUR DES UTILISATIONS OPTOÉLECTRONIQUES

(30) Priorität: 08.10.2014 EP 14188055
(43) Veröffentlichungstag der Anmeldung: 16.08.2017
(73) Patentinhaber: cynora GmbH, 76646 Bruchsal (DE)
(72) Erfinder: JACOB, Andreas, 30449 Hannover (DE)
(74) Vertreter: Hoppe, Georg Johannes
(86) Internationale Anmeldenummer: PCT/EP2015/073233
(87) Internationale Veröffentlichungsnummer: WO 2016/055557

(56) Entgegenhaltungen:
- EP-A1- 2 749 563
- WO-A2-2014/146749
- US-A1- 2008 064 893
- SETH B. HARKINS ET AL: "Probing the Electronic Structures of [Cu 2 ([mu]-XR 2 )] n + Diamond Cores as a Function of the Bridging X Atom (X = N or P) and Charge ( n = 0, 1, 2)", JOURNAL OF THE AMERICAN CHEMICAL SOCIETY, Bd. 130, Nr. 11, 26. Februar 2008 (2008-02-26), Seiten 3478-3485, XP055031757, ISSN: 0002-7863, DOI: 10.1021/ja076537v

## Beschreibung

Die Erfindung betrifft Metall(I)komplexe aufweisend eine Struktur der Formel A-3 nach Anspruch 1, deren Verwendung in optoelektronischen Bauelementen nach Anspruch 2, optoelektronische Bauelemente aufweisend einen derartigen Metall(I)komplex nach Anspruch 7 und ein Verfahren zur Herstellung eines optoelektronischen Bauelements nach Anspruch 9.

### Einleitung

Zur Zeit zeichnet sich ein drastischer Wandel im Bereich der Bildschirm- und Beleuchtungstechnik ab. Es wird möglich sein, flache Displays oder Leuchtflächen mit einer Dicke von unter 0,5 mm zu fertigen. Diese sind durch viele faszinierende Eigenschaften ausgezeichnet. So werden z. B. Leuchtflächen als Tapeten mit sehr geringem Energieverbrauch realisierbar sein. Ferner werden Farbbildschirme mit bisher nicht erreichbarer Farb-Echtheit, Helligkeit und Blickwinkelunabhängigkeit, mit geringem Gewicht sowie sehr niedrigem Stromverbrauch herstellbar sein. Die Bildschirme werden sich als Mikro-Displays oder Großbildschirme mit mehreren m² Fläche in starrer Form oder flexibel, aber auch als Transmissions- oder Reflexions-Displays gestalten lassen. Ferner wird es möglich sein, einfache und kostensparende Herstellungsverfahren wie Siebdruck oder Tintenstrahldruck oder Vakuum-Sublimation einzusetzen. Dadurch wird im Vergleich zu herkömmlichen Flachbildschirmen eine sehr preiswerte Fertigung ermöglicht. Diese neue Technik basiert auf dem Prinzip der **OLED**s, den **O**rganic **L**ight **E**mitting **D**iodes.

Derartige Bauteile bestehen vorwiegend aus organischen Schichten. Bei einer Spannung von z. B. 5 V bis 10 V treten aus einer leitenden Metallschicht, z. B. aus einer Aluminium-Kathode, negative Elektronen in eine dünne Elektronen-Leitungsschicht und wandern in Richtung der positiven Anode. Diese besteht z. B. aus einer durchsichtigen, aber elektrisch leitenden, dünnen Indium-Zinn-Oxid-Schicht, von der positive Ladungsträger, sog. Löcher, in eine organische Löcher-Leitungsschicht einwandern. Diese Löcher bewegen sich im Vergleich zu den Elektronen in entgegengesetzter Richtung, und zwar auf die negative Kathode zu. In einer mittleren Schicht, der Emitterschicht, die ebenfalls aus einem organischen Material besteht, befinden sich zusätzlich besondere Emitter-Moleküle, an denen oder in deren Nähe die beiden Ladungsträger rekombinieren und dabei zu neutralen, aber energetisch angeregten Zuständen der Emitter-Moleküle führen.

Die angeregten Zustände geben dann ihre Energie als helle Lichtemission ab, z. B. in blauer, grüner oder roter Farbe. Auch Weiß-Licht-Emission ist realisierbar. Auf die Emitterschicht kann gegebenenfalls auch verzichtet werden, wenn die Emittermoleküle sich in der Loch- oder Elektronen-Leitungsschicht befinden.

Die neuen OLED-Bauelemente lassen sich großflächig als Beleuchtungskörper oder auch äußerst klein als Pixel für Displays gestalten. Entscheidend für den Bau hoch-effektiver OLEDs sind die verwendeten Leuchtmaterialien (Emitter-Moleküle). Diese können in verschiedener Weise realisiert werden, und zwar unter Verwendung rein organischer oder metall-organischer Moleküle sowie von Komplexverbindungen. Es lässt sich zeigen, dass die Lichtausbeute der OLEDs mit metall-organischen Substanzen, den sog. Triplett-Emittern, wesentlich größer sein kann als für rein organische Materialien. Aufgrund dieser Eigenschaft kommt der Weiterentwicklung der metall-organischen Materialien ein wesentlicher Stellenwert zu. Die Funktion von OLEDs ist bereits sehr häufig beschrieben worden: C. Adachi, M. A. Baldo, S. R. Forrest, S. Lamansky, M. E. Thompson, R. C. Kwong, Appl. Phys. Lett. 2001, 78, 1622; X. H. Yang, D. C. Müller, D. Neher, K. Meerholz, Adv. Mater. 2006, 18, 948; X. H. Yang, D. Neher, Appl. Phys. Lett. 2004, 84, 2476; J. Shinar (Hrsg.), Organic light-emitting devices - A survey, AIP-Press, Springer, New York, 2004; H. Yersin, Top. Curr. Chem. 2004, 241, 1; H. Yersin, Highly Efficient OLEDs with Phosphorescent Materials, Wiley-VCH, Weinheim 2008; Z. H. Kafafi, Organic Electroluminescence, Taylor & Francis, Boca Raton, 2005. Unter Einsatz von metallorganischen Komplexen mit hoher Emissionsquantenausbeute (Übergänge unter Einbeziehung der untersten Triplett-Zustände zu den Singulett-Grundzuständen) lässt sich eine besonders hohe Effizienz des Devices erzielen. Diese Materialien werden häufig als Triplett-Emitter oder lumineszierende Emitter bezeichnet. Diese Erkenntnis ist seit längerem bekannt: C. Adachi, M. A. Baldo, S. R. Forrest, S. Lamansky, M. E. Thompson, R. C. Kwong, Appl. Phys. Lett. 2001, 78, 1622; X. H. Yang, D. C. Müller, D. Neher, K. Meerholz, Adv. Mater. 2006, 18, 948; X. H. Yang, D. Neher, Appl. Phys. Lett. 2004, 84, 2476; J. Shinar (Hrsg.), Organic light-emitting devices - A survey, AIP-Press, Springer, New York, 2004; H. Yersin, Top. Curr. Chem. 2004, 241, 1; H. Yersin, Highly Efficient OLEDs with Phosphorescent Materials, Wiley-VCH, Weinheim 2008. Für Triplett-Emitter sind folgende Dokumente einschlägig: M. E. Thompson, P. I. Djurovich, J. Li (University of Southern California, Los Angeles, CA), WO 2004/017043 A2, 2004; M. E. Thompson, P. I. Djurovich, R. Kwong (University of Southern California, Los Angeles, CA, Universal Display Corp, Ewing, NY), WO 2004/016711 A1, 2004; A. Tsuboyama, S. Okada, T. Takiguchi, K. Ueno, S. Igawa, J. Kamatani, M. Furugori, H. Iwawaki (Canon KK, Tokyo), WO 03/095587 A1, 2003; C.-M. Che, US 2003/0205707 A1, 2003; C.-M. Che, W. Lu, M. C.-W. Chan, US 2002/0179885 A1, 2002; J. Kamatani, S. Okada, A. Tsuboyama, T. Takiguchi, S. Igawa, US 2003/186080 A1, 2003; P. Stößel, I. Bach, A. Büsing (Covion Organic Semiconductors GmbH), DE 10350606 A1, 2005; M. Bold, C. Lennartz, M. Egen, H.-W. Schmidt, M. Thelakkat, M. Bäte, C. Neuber, W. Kowalsky, C. Schildknecht (BASF AG), DE 10338550 A1, 2005; C. Lennartz, A. Vogler, V. Pawlowski (BASF AG), DE 10358665 A1, 2005; B. Hsieh, T. P. S. Thoms, J. P. Chen (Canon KK, Tokyo), US 2006/989273 B2, 2006; N. Schulte, S. Heun, I. Bach, P. Stoessel, K. Treacher (Covion Organic Semiconductors), WO 2006/003000 A1, 2006; A. Vogler, V. Pawlowski, H.-W. Schmidt, M. Thelakkat (BASF AG), WO 2006/032449 A1, 2006; T. K. Hatwar, J. P. Spindler, R. H. Young (Eastman Kodak Co), WO 2006/028546 A1, 2006.

Einige Kupferkomplexe der Form Cu(L^L)(L'^L') und Cu2X2(L^L)2 mit L^L und L'^L' = bidentate Liganden und X = Halogenide sind bereits aus dem Stand der Technik bekannt. Sie zeigen intensive Lumineszenz bei Anregung mit UV-Licht. Die Lumineszenz stammt dabei meist von einem MLCT- (metal to ligand charge transfer) oder einem (MX)LCT-(metal-halogene to ligand charge transfer) Zustand. Weitere Einzelheiten zu ähnlichen Cu(I)-Systemen können der Literatur entnommen werden, beispielsweise Inorg. Chem., 2011, 50, 7172-7188, wobei die in dieser Druckschrift offenbarten Komplexe nur über eine sehr geringe Quanteneffizienz von unter 3 % verfügen (P. C. Ford, E. Cariati, J. Bourassa, Chem. Rev. 1999, 99, 3625; M. Hashimoto, S. Igawa, M. Yashima, I. Kawata, M. Hoshino, M. Osawa, J. Am. Chem. Soc. 2011, 10348; V.A. Krylova, P. I. Djurovich, M. T. Whited, M. E. Thompson, Chem. Commun. 2010, 6696. J. Lumin. 2009, 129, 181 - 186; J. Phys. Chem. C 2009, 113, 13968-13973; Appl. Phys. Lett. 2006, 89, 103511 - 103513).

Metallorganische Emitter weisen ein großes Potential zur Lichterzeugung in Displays (als Pixel) und in Beleuchtungsflächen (z. B. als Leuchttapete) auf. Sehr viele Triplett-EmitterMaterialien wurden bereits patentiert und werden mittlerweile auch technologisch in ersten Devices eingesetzt. Die bisherigen Lösungen weisen Nachteile und Probleme auf, und zwar in folgenden Bereichen:
- Langzeitstabilität der Emitter in den OLED-Devices,
- Thermische Stabilität,
- Chemische Stabilität gegenüber Wasser und Sauerstoff,
- Verfügbarkeit wichtiger Emissionsfarben,
- Fertigungstechnische Reproduzierbarkeit,
- Erreichbarkeit einer hohen Effizienz bei hohen Stromdichten,
- Erreichbarkeit sehr hoher Leuchtdichten,
- Hoher Preis der Emittermaterialien,
- Emittermaterialien sind toxisch und
- Synthesen sind aufwendig.

Vor diesem Hintergrund lag der vorliegenden Erfindung die Aufgabe zu Grunde, zumindest einige der oben genannten Nachteile zu überwinden.

In diesem Zusammenhang sind aus Harkins et al, JACS, 2008, 130, 3478-3485 zweikernige Kupferkomplexsalze bekannt. In US 2008/0064893 werden lumineszierende Metallkomplexe beschrieben, während aus der WO 2014/146749 Metallkomplexe für die Verwendung in optoelektronischen Vorrichtungen bekannt sind. Aus EP 2 749 563 sind zweikernige Metall(I)-Komplexe für optoelektronische Anwendungen bekannt.

### Beschreibung der Erfindung

Überraschend wurde gefunden, dass bestimmte Metallkomplexe zu deutlichen Verbesserungen bei organischen Elektrolumineszenzvorrichtungen führen, insbesondere hinsichtlich der Lebensdauer, der Effizienz und der Stabilität gegenüber Temperaturbelastung sowie der Möglichkeit, diese Vorrichtungen optional durch Prozessierung aus der Gasphase herzustellen.

Organische Elektrolumineszenzvorrichtungen, welche diese Metallkomplexe enthalten, sind ebenfalls Gegenstand der vorliegenden Erfindung.

Gemäß einem Aspekt der Erfindung werden Metall(I)komplexe aufweisend eine Struktur der Formel A-3 bereitgestellt, die weiter unten beschrieben werden.

Zunächst werden Metallkomplexe MLX beschrieben, die eine Struktur gemäß Formel A aufweisen oder von einer Struktur nach Formel A sind: 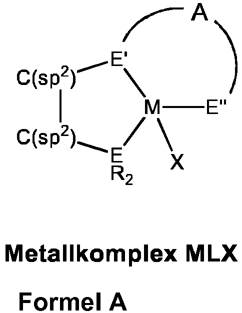 mit
M = ausgewählt aus der Gruppe bestehend aus Cu, Ag und Au;
C(sp²) = sp2-hybridisiertes Kohlenstoffatom, optional als Teil einer gegenüber Isomerisierung fixierten Doppelbindung oder eines aromatischen oder heteroaromatischen Ringsystems wie Benzol, Naphthalin, Anthracen, Furan, Benzofuran, Isobenzofuran, Dibenzofuran, Thiophen, Benzothiophen, Isobenzothiophen, Dibenzothiophen, Pyrrol, Indol, Isoindol, Carbazol, Pyridin, Chinolin, Isochinolin, Acridin, Phenanthridin, Benzo-5,6-chinolin, Benzo-6,7-chinolin, Benzo-7,8-chinolin, Phenothiazin, Phenoxazin, Pyrazol, Indazol, Imidazol, Benzimidazol, Naphthimidazol, Phenanthrimidazol, Pyridimidazol, Pyrazinimidazol, Chinoxalinimidazol, Oxazol, Benzoxazol, Naphthoxazol, Anthroxazol, Phenanthroxazol, Isoxazol, 1,2-Thiazol, 1,3-Thiazol, Benzothiazol, Pyridazin, Benzopyridazin, Pyrimidin, Benzpyrimidin, Chinoxalin, 1,5-Diazaanthracen, 2,7-Diazapyren, 2,3-Diazapyren, 1,6-Diazapyren, 1,8-Diazapyren, 4,5-Diazapyren, 4,5,9,10-Tetraazaperylen, Pyrazin, Phenazin, Phenoxazin, Phenothiazin, Fluorubin, Naphthyridin, Azacarbazol, Benzocarbolin, Phenanthrolin, 1,2,3-Triazol, 1,2,4-Triazol, Benzotriazol, 1,2,3-Oxadiazol, 1,2,4-Oxadiazol, 1,2,5-Oxadiazol, 1,3,4-Oxadiazol, 1,2,3-Thiadiazol, 1,2,4-Thiadiazol, 1,2,5-Thiadiazol, 1,3,4-Thiadiazol, 1,3,5-Triazin, 1,2,4-Triazin, 1,2,3-Triazin, Tetrazol, 1,2,4,5-Tetrazin, 1,2,3,4-Tetrazin, 1,2,3,5-Tetrazin, Purin, Pteridin, Indolizin und Benzothiadiazol;
A = Brücke mit mehr als einem und weniger als sechs (bezogen auf die kürzeste Kettenlänge) gleichen oder verschiedenen Kettengliedern k, bevorzugt mehr als ein und weniger als 4, stärker bevorzugt mehr als ein und weniger als 3, wobei k = C(sp²)R, CR₂, C=O, C=S, C=NR, O, N, NR, S, Se; optional sind ein oder mehrere Glieder von k auch Teil eines aromatischen oder aliphatischen Ringsystems wie bei C(sp²) definiert;
E = Arsen oder Phosphor;
E' = NR, PR, AsR, O, S, Se oder N als Teil eines Imin-Systems; bevorzugt NR, für NR und N optional auch als Bestandteil eines aromatischen oder aliphatischen Ringsystems, welches optional mit C(sp²) und/oder A anelliert sein kann zu einem Ringsystem wie Chinolin, Isochinolin, etc. (siehe Definition von C(sp²));
E" = entweder eine chemisch neutrale Gruppe ausgewählt aus C*R (Carben-Kohlenstoff), NR (Imin-Stickstoff), NR₂, PR₂, AsR₂, OR, SR, SeR, optional als Teil eines neutralen aromatischen oder heteroaromatischen Ringsystems wie bei C(sp²) definiert; oder
   eine einfach negativ geladene Gruppe ausgewählt aus der Gruppe bestehend aus NR, PR, AsR, O, S, Se, optional als Teil eines anionischen heteroaromatischen Ringsystems wie bei C(sp²) definiert;
X = ausgewählt aus der Gruppe bestehend aus Cl, Br, I, CN, OCN, SCN, Alkinyl und N₃, wobei X nur bei E" = eine chemisch neutrale Gruppe vorhanden ist;
R ist bei jedem Auftreten unabhängig voneinander ausgewählt aus der Gruppe bestehend aus H, Deuterium, Phenyl, Naphthyl, F, Cl, Br, I, N(R²)₂, -CN, -NC, -SCN, -CF₃, -NO₂, -OH, C(=O)OH, C(=O)OR³, C(=O)N(R³)₂, C(=O)SR³, C(=S)SR³, Si(R⁴)₃, B(OR⁵)₂, B(N(R⁶)₂)₂, C(=O)R³, P(=O)(R⁷)₂, As(=O)(R⁷)₂, P(=S)(R⁷)₂, As(=S)(R⁷)₂, S(=O)R³, S=NR³, S(=O)NR³, S(=O)₂NR³, S(=O)₂R³, O-S(=O)₂R³, SF₅, eine lineare Alkyl-, Alkoxy- oder Thioalkoxygruppe mit 1 bis 40 C-Atomen oder eine lineare Alkenyl- oder Alkinylgruppe mit 2 bis 40 C-Atomen oder eine verzweigte oder cyclische Alkyl-, Alkenyl-, Alkinyl-, Alkoxy- oder Thioalkoxygruppe mit 3 bis 40 C-Atomen, die jeweils mit einem oder mehreren Resten R⁹ substituiert sein kann, wobei eine oder mehrere benachbarte CH₂-Gruppen durch -R⁹C=CR⁹-, -C=C-, bzw. eine benachbarte CH₂-Gruppe durch -Si(R⁴)₂-, -Ge(R⁴)₂-, - Sn(R⁴)₂, -C(=O)-, -C(=S)-, -C(=Se)-, -C=N-, -C(=O)O-, -C(=O)N(R³)-, -P(=O)(R⁷)-, - As(=O)(R⁷)-, -P(=S)(R⁷)-, -As(=S)(R⁷)-, -S(=O)-, -S(=O)₂-, -NR²-, -O-, oder -S- ersetzt sein können und wobei ein oder mehrere H-Atome durch Deuterium, F, Cl, Br, I, CN, CF₃ oder NO₂ ersetzt sein können, oder ein aromatisches oder heteroaromatisches Ringsystem mit 5 bis 60 aromatischen Ringatomen, das jeweils durch einen oder mehrere Reste R² substituiert sein kann, oder eine Aryloxy- oder Heteroaryloxygruppe mit 5 bis 60 aromatischen Ringatomen, die durch einen oder mehrere Reste R⁹ substituiert sein kann, oder eine Diarylaminogruppe, Diheteroarylaminogruppe oder Arylheteroarylaminogruppe mit 10 bis 40 aromatischen Ringatomen, welche durch einen oder mehrere Reste R⁹ substituiert sein kann, oder eine Kombination dieser Systeme; dabei können zwei oder mehrere dieser Substituenten R auch miteinander ein monozyklisches aliphatisches Ringsystem mit insgesamt fünf oder sechs Ringgliedern bilden;
R² ist bei jedem Auftreten unabhängig voneinander ausgewählt aus der Gruppe bestehend aus H, Deuterium, Phenyl, Naphthyl, CF₃, C(=O)OR³, Si(R⁴)₃, C(=O)R³, P(=O)(R⁷)₂, As(=O)(R⁷)₂ P(=S)(R⁷)₂, As(=S)(R⁷)₂, S(=O)R³, S(=O)₂R³, eine lineare Alkyl-, Alkoxy- oder Thioalkoxygruppe mit 1 bis 40 C-Atomen oder eine lineare Alkenyl- oder Alkinylgruppe mit 2 bis 40 C-Atomen oder eine verzweigte oder cyclische Alkyl-, Alkenyl-, Alkinyl-, Alkoxy- oder Thioalkoxygruppe mit 3 bis 40 C-Atomen, die jeweils mit einem oder mehreren Resten R⁹ substituiert sein kann, wobei eine oder mehrere benachbarte CH₂-Gruppen durch -R⁹C=CR⁹-, -C=C-, bzw. eine benachbarte CH₂-Gruppe durch -Si(R⁴)₂-, -Ge(R⁴)₂-, - Sn(R⁴)₂, -C(=O)-, -C(=S)-, -C(=Se)-, -C=N-, -C(=O)O-, -C(=O)N(R³)-, -P(=O)(R⁷)-, - As(=O)(R⁷)-, -P(=S)(R⁷)-, -As(=S)(R⁷)-, -S(=O)-, -S(=O)₂-, -NR²-, -O-, oder -S-ersetzt sein können und wobei ein oder mehrere H-Atome durch Deuterium, F, Cl, Br, I, CN, CF₃ oder NO₂ ersetzt sein können, oder ein aromatisches oder heteroaromatisches Ringsystem mit 5 bis 60 aromatischen Ringatomen, das jeweils durch einen oder mehrere Reste R⁹ substituiert sein kann, oder eine Aryloxy- oder Heteroaryloxygruppe mit 5 bis 60 aromatischen Ringatomen, die durch einen oder mehrere Reste R⁹ substituiert sein kann, oder eine Diarylaminogruppe, Diheteroarylaminogruppe oder Arylheteroarylaminogruppe mit 10 bis 40 aromatischen Ringatomen, welche durch einen oder mehrere Reste R⁹ substituiert sein kann, oder eine Kombination dieser Systeme; dabei können zwei oder mehrere dieser Substituenten R² auch miteinander ein mono- oder polycyclisches, aliphatisches, aromatisches und/oder benzoannelliertes Ringsystem bilden;
R³ ist bei jedem Auftreten unabhängig voneinander ausgewählt aus der Gruppe bestehend aus H, Deuterium, Phenyl, Naphthyl, CF₃ oder ein aliphatischer, aromatischer und/oder heteroaromatischer Kohlenwasserstoffrest mit 1 bis 20 C-Atomen, in dem auch ein oder mehrere H-Atome durch F oder CF₃ ersetzt sein können; dabei können zwei oder mehrere Substituenten R³ auch miteinander ein mono- oder polycyclisches, aliphatisches Ringsystem bilden;
R⁴ ist bei jedem Auftreten unabhängig voneinander ausgewählt aus der Gruppe bestehend aus H, Deuterium, Phenyl, Naphthyl, CN, CF₃, OH, C(=O)OR³, C(=O)N(R³)₂, C(=O)R³ P(=O)(R⁷)₂, As(=O)(R⁷)₂, P(=S)(R⁷)₂, As(=S)(R⁷)₂, eine lineare Alkyl-, Alkoxy- oder Thioalkoxygruppe mit 1 bis 40 C-Atomen oder eine lineare Alkenyl- oder Alkinylgruppe mit 2 bis 40 C-Atomen oder eine verzweigte oder cyclische Alkyl-, Alkenyl-, Alkinyl-, Alkoxy- oder Thioalkoxygruppe mit 3 bis 40 C-Atomen, die jeweils mit einem oder mehreren Resten R⁹ substituiert sein kann, wobei eine oder mehrere benachbarte CH₂-Gruppen durch -R⁹C=CR⁹-, -C=C-, bzw. eine benachbarte CH₂-Gruppe durch, -C(=O)-, -C(=S)-, - C(=Se)-, -C=N-, -C(=O)O-, -C(=O)N(R³)-, -P(=O)(R⁷)-, -As(=O)(R⁷)-, -P(=S)(R⁷)-, - As(=S)(R⁷)-, -S(=O)-, -S(=O)₂-, -O-, oder -S- ersetzt sein können und wobei ein oder mehrere H-Atome durch Deuterium, F, Cl, Br, I, CN, CF₃ oder NO₂ ersetzt sein können, oder ein aromatisches oder heteroaromatisches Ringsystem mit 5 bis 60 aromatischen Ringatomen, das jeweils durch einen oder mehrere Reste R⁸ substituiert sein kann, oder eine Aryloxy- oder Heteroaryloxygruppe mit 5 bis 60 aromatischen Ringatomen, die durch einen oder mehrere Reste R⁹ substituiert sein kann, oder eine Diarylaminogruppe, Diheteroarylaminogruppe oder Arylheteroarylaminogruppe mit 10 bis 40 aromatischen Ringatomen, welche durch einen oder mehrere Reste R⁹ substituiert sein kann, oder eine Kombination dieser Systeme; dabei können zwei oder mehrere dieser Substituenten R⁴ auch miteinander ein mono- oder polycyclisches, aliphatisches, aromatisches und/oder benzoannelliertes Ringsystem bilden;
R⁵ ist bei jedem Auftreten unabhängig voneinander ausgewählt aus der Gruppe bestehend aus Phenyl, Naphthyl, CF₃, C(=O)R³, P(=O)(R⁷)₂, As(=O)(R⁷)₂, eine lineare Alkyl-, Alkoxy- oder Thioalkoxygruppe mit 1 bis 40 C-Atomen oder eine lineare Alkenyl- oder Alkinylgruppe mit 2 bis 40 C-Atomen oder eine verzweigte oder cyclische Alkyl-, Alkenyl-, Alkinyl-, Alkoxy- oder Thioalkoxygruppe mit 3 bis 40 C-Atomen, die jeweils mit einem oder mehreren Resten R⁹ substituiert sein kann, wobei eine oder mehrere benachbarte CH₂-Gruppen durch -R⁹C=CR⁹-, -C=C-, bzw. eine benachbarte CH₂-Gruppe durch -Si(R⁴)₂-, - Ge(R⁴)₂-, -Sn(R⁴)₂, -C(=O)-, -C(=S)-, -C(=Se)-, -C=N-, -C(=O)O-, -C(=O)N(R³)-, - P(=O)(R⁷)-, -As(=O)(R⁷)-, -P(=S)(R⁷)-, -As(=S)(R⁷)-, -S(=O)-, -S(=O)₂-, -NR²-, -O-, oder -S-ersetzt sein können und wobei ein oder mehrere H-Atome durch Deuterium, F, Cl, Br, I, CN, CF₃ oder NO₂ ersetzt sein können, oder ein aromatisches oder heteroaromatisches Ringsystem mit 5 bis 60 aromatischen Ringatomen, das jeweils durch einen oder mehrere Reste R⁹ substituiert sein kann, oder eine Aryloxy- oder Heteroaryloxygruppe mit 5 bis 60 aromatischen Ringatomen, die durch einen oder mehrere Reste R⁹ substituiert sein kann, oder eine Diarylaminogruppe, Diheteroarylaminogruppe oder Arylheteroarylaminogruppe mit 10 bis 40 aromatischen Ringatomen, welche durch einen oder mehrere Reste R⁹ substituiert sein kann, oder eine Kombination dieser Systeme; dabei können zwei oder mehrere dieser Substituenten R⁵ auch miteinander ein mono- oder polycyclisches, aliphatisches, aromatisches und/oder benzoannelliertes Ringsystem bilden;
R⁶ ist bei jedem Auftreten unabhängig voneinander ausgewählt aus der Gruppe bestehend aus Phenyl, Naphthyl, CF₃, Si(R⁴)₃, C(=O)R³, P(=O)(R⁷)₂, eine lineare Alkyl-, Alkoxy- oder Thioalkoxygruppe mit 1 bis 40 C-Atomen oder eine lineare Alkenyl- oder Alkinylgruppe mit 2 bis 40 C-Atomen oder eine verzweigte oder cyclische Alkyl-, Alkenyl-, Alkinyl-, Alkoxy- oder Thioalkoxygruppe mit 3 bis 40 C-Atomen, die jeweils mit einem oder mehreren Resten R⁹ substituiert sein kann, wobei eine oder mehrere benachbarte CH₂-Gruppen durch -R⁹C=CR⁹-, -C=C-, bzw. eine benachbarte CH₂-Gruppe durch-Si(R⁴)₂-, -Ge(R⁴)₂-, - Sn(R⁴)₂, -C(=O)-, -C(=S)-, -C(=Se)-, -C=N-, -C(=O)O-, -C(=O)N(R³)-, -P(=O)(R⁷)-, - As(=O)(R⁷)-, -P(=S)(R⁷)-, -As(=S)(R⁷)-, -S(=O)-, -S(=O)₂-, -NR²-, -O-, oder -S- ersetzt sein können und wobei ein oder mehrere H-Atome durch Deuterium, F, Cl, Br, I, CN, CF₃ oder NO₂ ersetzt sein können, oder ein aromatisches oder heteroaromatisches Ringsystem mit 5 bis 60 aromatischen Ringatomen, das jeweils durch einen oder mehrere Reste R⁹ substituiert sein kann, oder eine Aryloxy- oder Heteroaryloxygruppe mit 5 bis 60 aromatischen Ringatomen, die durch einen oder mehrere Reste R substituiert sein kann, oder eine Diarylaminogruppe, Diheteroarylaminogruppe oder Arylheteroarylaminogruppe mit 10 bis 40 aromatischen Ringatomen, welche durch einen oder mehrere Reste R⁹ substituiert sein kann, oder eine Kombination dieser Systeme; dabei können zwei oder mehrere dieser Substituenten R⁶ auch miteinander ein mono- oder polycyclisches, aliphatisches, aromatisches und/oder benzoannelliertes Ringsystem bilden;
R⁷ ist bei jedem Auftreten unabhängig voneinander ausgewählt aus der Gruppe bestehend aus Phenyl, Naphthyl, CN, CF₃, C(=O)OR³, C(=O)N(R³)₂, C(=O)R³, eine lineare Alkyl-, Alkoxy- oder Thioalkoxygruppe mit 1 bis 40 C-Atomen oder eine lineare Alkenyl- oder Alkinylgruppe mit 2 bis 40 C-Atomen oder eine verzweigte oder cyclische Alkyl-, Alkenyl-, Alkinyl-, Alkoxy- oder Thioalkoxygruppe mit 3 bis 40 C-Atomen, die jeweils mit einem oder mehreren Resten R⁹ substituiert sein kann, wobei eine oder mehrere benachbarte CH₂-Gruppen durch -R⁹C=CR⁹-, -C=C-, bzw. eine benachbarte CH₂-Gruppe durch -C(=O)-, - C(=S)-, -C(=Se)-, -C=N-, -C(=O)O-, -C(=O)N(R³)-, -S(=O)-, -S(=O)₂-, -O-, oder -S- ersetzt sein können und wobei ein oder mehrere H-Atome durch Deuterium, F, Cl, Br, I, CN, CF₃ oder NO₂ ersetzt sein können, oder ein aromatisches oder heteroaromatisches Ringsystem mit 5 bis 60 aromatischen Ringatomen, das jeweils durch einen oder mehrere Reste R⁹ substituiert sein kann, oder eine Aryloxy- oder Heteroaryloxygruppe mit 5 bis 60 aromatischen Ringatomen, die durch einen oder mehrere Reste R⁹ substituiert sein kann, oder eine Diarylaminogruppe, Diheteroarylaminogruppe oder Arylheteroarylaminogruppe mit 10 bis 40 aromatischen Ringatomen, welche durch einen oder mehrere Reste R³ substituiert sein kann, oder eine Kombination dieser Systeme; dabei können zwei oder mehrere dieser Substituenten R⁷ auch miteinander ein mono- oder polycyclisches, aliphatisches, aromatisches und/oder benzoannelliertes Ringsystem bilden;
R⁸ ist bei jedem Auftreten unabhängig voneinander ausgewählt aus der Gruppe bestehend aus H, Deuterium, Phenyl, Naphthyl, F, CF₃ oder ein aliphatischer, aromatischer und/oder heteroaromatischer Kohlenwasserstoffrest mit 1 bis 20 C-Atomen, in dem auch ein oder mehrere H-Atome durch F oder CF₃ ersetzt sein können; dabei können zwei oder mehrere Substituenten R⁸ auch miteinander ein mono- oder polycyclisches, aliphatisches Ringsystem bilden;
R⁹ ist bei jedem Auftreten unabhängig voneinander ausgewählt aus der Gruppe bestehend aus H, Deuterium, Phenyl, Naphthyl, CN, CF₃, NO₂, OH, COOH, C(=O)OR³, C(=O)N(R³)₂, C(=O)R³, S(=O)R³, S(=O)₂R³, OSO₂R³, eine lineare Alkyl-, Alkoxy- oder Thioalkoxygruppe mit 1 bis 40 C-Atomen oder eine lineare Alkenyl- oder Alkinylgruppe mit 2 bis 40 C-Atomen oder eine verzweigte oder cyclische Alkyl-, Alkenyl-, Alkinyl-, Alkoxy- oder Thioalkoxygruppe mit 3 bis 40 C-Atomen, die jeweils mit einem oder mehreren Resten R⁸ substituiert sein kann, wobei eine oder mehrere nicht benachbarte CH₂-Gruppen durch - R³C=CR³-, -C=C-, bzw. eine benachbarte CH₂-Gruppe durch, -C(=O)-, -C(=S)-, -C(=Se)-, - C=N-, -C(=O)O-, -C(=O)N(R³)-, -S(=O)-, -S(=O)₂-, -O-, oder -S- ersetzt sein können und wobei ein oder mehrere H-Atome durch Deuterium, F, Cl, Br, I, CN, CF₃ oder NO₂ ersetzt sein können, oder ein aromatisches oder heteroaromatisches Ringsystem mit 5 bis 60 aromatischen Ringatomen, das jeweils durch einen oder mehrere Reste R⁸ substituiert sein kann, oder eine Aryloxy- oder Heteroaryloxygruppe mit 5 bis 60 aromatischen Ringatomen, die durch einen oder mehrere Reste R³ substituiert sein kann, oder eine Diarylaminogruppe, Diheteroarylaminogruppe oder Arylheteroarylaminogruppe mit 10 bis 40 aromatischen Ringatomen, welche durch einen oder mehrere Reste R⁸ substituiert sein kann, oder eine Kombination dieser Systeme; dabei können zwei oder mehrere dieser Substituenten R⁹ auch miteinander ein mono- oder polycyclisches, aliphatisches, aromatisches und/oder benzoannelliertes Ringsystem bilden.

Eine Arylgruppe im Sinne dieser Erfindung enthält 6 bis 60 aromatische Ringatome; eine Heteroarylgruppe im Sinne dieser Erfindung enthält 5 bis 60 aromatische Ringatome, von denen mindestens eines ein Heteroatom darstellt. Die Heteroatome sind bevorzugt N, O, und S. Werden in der Beschreibung der vorliegenden Erfindung andere Ausführungen angegeben, beispielsweise bezüglich der Zahl der aromatischen Ringatome oder der enthaltenen Heteroatome, so gelten diese.

Dabei wird unter einer Arylgruppe bzw. Heteroarylgruppe ein einfacher aromatischer Cyclus, also Benzol, bzw. ein einfacher heteroaromatischer Cyclus, beispielsweise Pyridin, Pyrimidin oder Thiophen, oder ein heteroaromatischer Polycyclus, beispielsweise Napthalin, Phenanthren, Chinolin oder Carbazol verstanden. Ein kondensierter (annelierter) aromatischer bzw. heteroaromatischer Polycyclus besteht im Sinne der vorliegenden Anmeldung aus zwei oder mehr miteinander kondensierten einfachen aromatischen bzw. heteroaromatischen Cyclen.

Unter einer Aryl- oder Heteroarylgruppe, die jeweils mit den oben genannten Resten substituiert sein kann und die über beliebige Positionen am Aromaten bzw. Heteroaromaten verknüpft sein kann, werden insbesondere Gruppen verstanden, welche abgeleitet sind von Benzol, Naphthalin, Anthracen, Phenanthren, Pyren, Dihydropyren, Chrysen, Perylen, Fluoranthen, Benzanthracen, Benzphenanthren, Tetracen, Pentacen, Benzpyren, Furan, Benzofuran, Isobenzofuran, Dibenzofuran, Thiophen, Benzothiophen, Isobenzothiophen, Dibenzothiophen; Pyrrol, Indol, Isoindol, Carbazol, Pyridin, Chinolin, Isochinolin, Acridin, Phenanthridin, Benzo-5,6-chinolin, Isochinolin, Benzo-6,7-chinolin, Benzo-7,8-chinolin, Phenothiazin, Phenoxazin, Pyrazol, Indazol, Imidazol, Benzimidazol, Naphthimidazol, Phenanthrimidazol, Pyridimidazol, Pyrazinimidazol, Chinoxalinimidazol, Oxazol, Benzoxazol, Napthoxazol, Anthroxazol, Phenanthroxazol, Isoxazol, 1,2-Thiazol, 1,3-Thiazol, Benzothiazol, Pyridazin, Benzopyridazin, Pyrimidin, Benzpyrimidin, Chinoxalin, Pyrazin, Phenazin, Naphthyridin, Azacarbazol, Benzocarbolin, Phenanthrolin, 1,2,3-Triazol, 1,2,4-Triazol, Benztriazol, 1,2,3-Oxadiazol, 1,2,4-Oxadiazol, 1,2,5-Oxadiazol, 1,2,3,4-Tetrazin, Purin, Pteridin, Indolizin und Benzothiadiazol.

Ein aromatisches Ringsystem im Sinne dieser Erfindung enthält 6 bis 60 C-Atome im Ringsystem. Ein heteroaromatisches Ringsystem im Sinne dieser Erfindung enthält 5 bis 60 aromatische Ringatome, von denen mindestens eines ein Heteroatom darstellt. Die Heteroatome sind bevorzugt ausgewählt aus, N, O und/oder S. Unter einem aromatischen oder heteroaromatischen Ringsystem im Sinne dieser Erfindung soll ein System verstanden werden, das nicht notwendigerweise nur Aryl- oder Heteroarylgruppen enthält, sondern in dem auch mehrere Aryl- oder Heteroarylgruppen durch eine nicht-aromatische Einheit (bevorzugt weniger als 10% der verschiedenen Atome), wie z.B. ein sp3-hybridisiertes C-, Si-, oder N-Atom, ein sp2-hybridisiertes C-, N- oder O-Atom oder ein sphybridisiertes C-Atom, verbunden sein können. So sollen beispielsweise auch System wie 9,9'-Diarylfluoren, Triarylamin, Diarylether, Stilben etc als aromatische Ringsysteme im Sinne dieser Erfindung verstanden werden, und ebenso Systeme, in denen zwei oder mehrere Arylgruppen beispielsweise durch eine lineare oder cyclische Alkyl-, Alkenyl- oder Alkinylgruppen oder durch eine Silylgruppe verbunden sind. Weiterhin werden auch Systeme, in denen zwei oder mehr Aryl- oder Heteroyraylgruppen über Einfachbindungen miteinander verknüpft sind, als aromatische oder heteroaromatische Ringsysteme im Sinne dieser Erfindung verstanden, wie beispielsweise Systeme wie Biphenyl, Terphenyl oder Diphenyltriazin.

Unter einem aromatischen oder heteroaromatischen Ringsystem mit 5 bis 60 aromatischen Ringatomen, welches noch jeweils mit Resten wie oben definiert substituiert sein kann und welches über beliebige Positionen am Aromaten bzw. Heteroaromaten verknüpft sein kann, werden insbesondere Gruppen verstanden, die abgeleitet sind von Benzol, Naphthalin, Anthracen, Benzanthracen, Phenanthren, Benzphenanthren, Pyren, Chrysen, Perylen, Fluoranthen, Napthacen, Pentacen, Benzpyren, Biphenyl, Biphenylen, Terphenyl, Terphenylen, Quaterphenyl, Fluoren, Spirobifluoren, Dihydrophenanthren, Dihydropyren, Tetrahydropyren, cis- oder trans-Indenofluoren, Truxen, Isotruxen, Spirotruxen, Spiroisotruxen, Furan, Benzofuran, Isobenzofuran, Dibenzofuran, Thiophen, Benzothiophen, Isobenzothiophen, Dibenzothiophen, Pyrrol, Indol, Isoindol, Carbazol, Indolocarbazol, Indenocarbazol, Pyridin, Chinolin, Isochinolin, Acridin, Phenanthridin, Benzo-5,6-chinolin Benzo-6,7-chinolin, Benzo-7,8-chinolin, Phenothiazin, Phenoxazin, Pyrazol, Indazol, Imidazol, Benzimidazol, Naphthimidazol, Phenanthrimidazol, Pyridimidazol, Pyarzinimidazol, Chinoxalinimidazol, Oxazol, Benzoxazol, Napthoxazol, Anthroxazol, Phenanthroxazol, Isoxazol, 1,2-Thiazol, 1,3-Thiazol, Benzothiazol, Pyridazin, Benzopyridazin, Pyrimidin, Benzpyrimidin, Chinoxalin, 1,5-Diazaanthracen, 2,7-Diazapyren, 2,3-Diazapyren, 1,6-Diazapyren, 1,8-Diazapyren, 4,5-Diazapyren, 4,5,9,10-Tetraazaperylen, Pyrazin, Phenazin, Phenoxazin, Phenothiazin, Fluorubin, Naphthyridin, Azacarbazol, Benzocarbolin, Phenanthrolin, 1,2,3-Triazol, 1,2,4-Triazol, Benzotriazol, 1,2,3-Oxadiazol, 1,2,4-Oxadiazol, 1,2,5-Oxadiazol, 1,2,3 Oxadiazol, 1,2,3-Thiadiazol, 1,2,5-Thiadiazol, 1,3,4-Thiadiazol, 1,3,5-Triazin, 1,2,4-Triazin, 1,2,3-Triazin, Tetrazol, 1,2,3,5-Tetrazin, 1,2,3,4-Tetrazin, Purin, Pteridin, Indolizin und Benzothiadiazol oder Kombinationen dieser Gruppen.

Bevorzugt sind Metallkomplexe gemäß Formel A, bei denen die Summe der Valenzelektronen um das Metallatom 18 beträgt. Diese Bevorzugung ist durch die besondere Stabilität dieser Metallkomplexe begründet.

Die Metallkomplexe MLX weisen einen Liganden L mit einer Struktur der Formel B auf (Teil der Formel A), 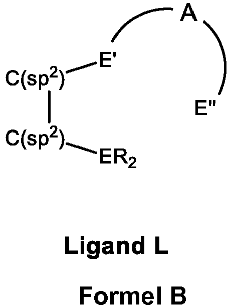 wobei die in Formel B angegebenen Symbole die bei Formel A angegebene Bedeutung haben.
Bei dem Liganden L handelt es sich somit um einen tridentaten, nicht-makrocyclischen Liganden, welcher über die drei Donoratome E, E' und E" an das Metall M bindet. Unter einem Donoratom im Sinne der vorliegenden Erfindung wird ein Atom verstanden, das mindestens ein freies Elektronenpaar aufweist und dadurch in der Lage ist, an ein Metallatom bzw. Metallion zu binden. Dabei kann das Donoratom neutral oder negativ geladen sein. Bevorzugt ist das Donoratom neutral oder negativ geladen. Beispiele für neutrale Donoratome sind Stickstoff, welcher in einem Heteroaromaten wie z. B. Pyridin gebunden ist, oder Kohlenstoff in Form eines Carbens. Beispiele für anionische Donoratome sind Stickstoffatome, welche Teil einer Fünfring-heteroaromatischen Gruppe sind, wie z. B. Stickstoff im Pyrrol, welches über den Stickstoff bindet. Unter einem exocyclischen Donoratom im Sinne dieser Erfindung wird ein Donoratom verstanden, welches nicht Teil des Metallacyclus mit den Ringgliedern (E-C(sp2)-C(sp2)-E'-M), welcher aus M und L gebildet wird, ist, sondern welches als Substituent an L gebunden ist und welches mindestens ein freies Elektronenpaar aufweist und dadurch in der Lage ist, an ein Metallatom zu binden. Beispiele für exocyclische Donoratome sind Sauerstoff in Form eines Phenolats, Schwefel in Form eines Thiolats, Stickstoff in Form eines Nitrils, Amins, Imins, Amids oder Imids, Phosphor in Form eines Phosphins oder Phosphits.

Durch die Kombination von verschiedenen Donorelementen wird die Stabilität des Metallkomplexes erhöht. Insbesondere durch die zwingend erforderliche Anwesenheit eines Pnictid-Donors wie As oder P steigt die Redoxstabilität, sodass luftstabile Substanzen erhalten werden. Dies erleichtert den praktischen Umgang bei der Bauteilproduktion enorm. Im Gegensatz zu US 2012/0286254, die ausschließlich Stickstoffdonoren verwendet, resultiert eine reduzierte Oxidationsempfindlichkeit der Komplexe. Hinsichtlich ihrer Verwendung in optoelektronischen Bauelementen zeichnen sich die erfindungsgemäßen Metall(I)komplexe durch einen weiten Bereich von erzielbaren Emissionsfarben aus. Zudem ist die Emissionsquantenausbeute hoch, insbesondere größer als 50 %. Für Emitterkomplexe mit Cu-Zentralion, sind die Emissionsabklingzeiten erstaunlich kurz.

Außerdem sind die erfindungsgemäßen Kupfer(I)komplexe in relativ hohen Emitterkonzentrationen ohne deutliche Quencheffekte verwendbar. Das heißt, in der Emissionsschicht können Emitterkonzentrationen von 5 % bis 100 % verwendet werden.

In einer besonderen Ausführungsform der Beschreibung werden Metallkomplexe MLX der Struktur der Formel A mit M = Cu verwendet. Besonders Kupfer(I) Komplexe wurden in der Vergangenheit erfolgreich in OLEDs eingesetzt und zeigen häufig vorteilhafte Eigenschaften wie eine hohe Effizienz und gute Einstellbarkeit der Emissionsfarbe. Durch die Beschränkung auf einen Metallkern wird insbesondere die Verdampfbarkeit erleichtert. Oft nimmt mit zunehmender Zahl an Metallkernen die Verdampfbarkeit einer Verbindung ab, wodurch diese nicht für die Prozessierung aus der Gasphase geeignet ist. Die Stabilität eines OLED-Bauteils hängt stark von der Reinheit der verwendeten Verbindungen ab, die allerdings am besten durch Sublimation gewährleistet werden kann. Durch dieses Verfahren lassen sich die Komplexe leicht in hoher Reinheit, bevorzugt in einer Reinheit von > 99 % nach <1>H-NMR oder HPLC, besonders bevorzugt > 99.9 % erhalten.

Eine weitere Ausführungsform der Beschreibung betrifft Metallkomplexe MLX aufweisend eine Struktur der Formel A-1 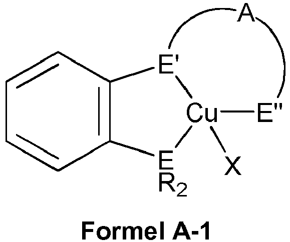 wobei für E, E', E", A, X und R die oben genannten Definitionen gelten.

In einer Ausführungsform der Beschreibung weist der Metallkomplex MLX eine Struktur der Formel A-2 auf 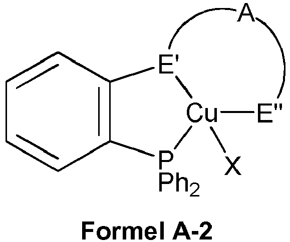 wobei für E', E", A und X die oben genannten Definitionen gelten; Ph = Phenyl.

In einem Aspekt der Erfindung weist der Metallkomplex MLX eine Struktur der Formel A-3 auf 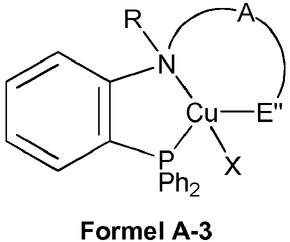 wobei für E", A, X und R die oben genannten Definitionen gelten; Ph = Phenyl.

In einer Ausführungsform werden die erfindungsgemäßen Komplexe in einer organischen elektronischen Vorrichtung verwendet. Darunter wird eine elektronische Vorrichtung verstanden, welche Anode, Kathode und mindestens eine Schicht enthält, wobei diese Schicht mindestens eine organische Verbindung enthält. Die erfindungsgemäße organische elektronische Vorrichtung enthält also Anode, Kathode und mindestens eine Schicht, welche mindestens einen erfindungsgemäßen Komplex (also ein, zwei, drei oder mehr erfindungsgemäße Komplexe) enthält. Dabei sind bevorzugte organische elektronische Vorrichtungen ausgewählt aus der Gruppe bestehend aus organischen Elektrolumineszenzvorrichtungen (= organischen Leuchtdioden, OLEDs, PLEDs), organischen integrierten Schaltungen (O-ICs), organischen Feld-Effekt-Transistoren (O-FETs), organischen Dünnfilmtransistoren (O-TFTs), organischen lichtemittierenden Transistoren (O-LETs), organischen Solarzellen (O-SCs), organischen optischen Detektoren, organischen Photorezeptoren, organischen Feld-Quench-Devices (O-FQDs), lichtemittierenden elektrochemischen Zellen (LECs) oder organischen Laserdioden (O-Laser), enthaltend in mindestens einer Schicht mindestens einen erfindungsgemäßen Komplexe. Bevorzugt sind entsprechende organische Elektrolumineszenzvorrichtungen.

Die erfindungsgemäßen Metallkomplexe werden in der organischen elektronischen oder optoelektronischen Vorrichtung als aktive Komponente verwendet. Unter der Bezeichnung "optoelektronische Bauelemente" werden insbesondere verstanden:
- Organische lichtemittierende Bauteile (organic light emitting diodes, OLEDs)
- lichtemittierende elektrochemische Zellen (light emitting electrochemical cells, LECs, LEECs),
- OLED-Sensoren, insbesondere in nicht hermetisch nach außen abgeschirmten Gas- und Dampf-Sensoren,
- organische Solarzellen (organic solar cells, OSCs, organic photovoltaics, OPVs),
- organische Feldeffekttransistoren und
- organische Laser.

Aktive Komponenten sind generell die organischen oder anorganischen Materialien, welche zwischen Anode und Kathode eingebracht sind, beispielsweise Ladungsinjektions-, Ladungstransport- oder Ladungsblockiermaterialien, insbesondere aber Emissionsmaterialien und Matrixmaterialien. Für diese Funktionen zeigen die erfindungsgemäßen Verbindungen besonders gute Eigenschaften, insbesondere als Emissionsmaterial in organischen Elektrolumineszenzvorrichtungen, wie im Folgenden noch näher ausgeführt wird. Ein Aspekt der Erfindung betrifft daher organische Elektrolumineszenzvorrichtungen. Eine derartige organische Elektrolumineszenzvorrichtung enthält eine Kathode, eine Anode und mindestens eine emittierende Schicht. Außer diesen Schichten kann sie noch weitere Schichten enthalten, beispielsweise jeweils eine oder mehrere Lochinjektionsschichten, Lochtransportschichten, Lochblockierschichten, Elektronentransportschichten, Elektroneninjektionsschichten, Excitonenblockierschichten, Ladungserzeugungsschichten. Ebenso können zwischen zwei emittierenden Schichten Zwischenschichten eingebracht sein, welche beispielsweise eine Excitonen-blockierende Funktion aufweisen. Es sei aber darauf hingewiesen, dass nicht notwendigerweise jede dieser Schichten vorhanden sein muss. Dabei kann die organische Elektrolumineszenzvorrichtung eine emittierende Schicht enthalten, oder sie kann mehrere emittierende Schichten enthalten, wobei mindestens eine emittierende Schicht mindestens eine Verbindung gemäß Formel A enthält. Wenn mehrere Emissionsschichten vorhanden sind, weisen diese bevorzugt insgesamt mehrere Emissionsmaxima zwischen 380 nm und 750 nm auf, so dass insgesamt weiße Emission resultiert, d. h. in den emittierenden Schichten werden verschiedene emittierende Verbindungen verwendet, die fluoreszieren oder phosphoreszieren können. Insbesondere bevorzugt sind Dreischichtsysteme, wobei die drei Schichten blaue, grüne und orange oder rote Emission zeigen (für den prinzipiellen Aufbau siehe z. B. WO 05/011013 A).

In einer bevorzugten Ausführungsform der Erfindung enthält die organische elektronische Vorrichtung mindestens einen erfindungsgemäßen Komplex, insbesondere einen oder mehrere Komplexe aufweisend oder bestehend aus einer Struktur nach Formel A3, als emittierende Verbindung in einer emittierenden Schicht. Dies ist insbesondere dann der Fall, wenn das Metall Kupfer, Silber oder Gold ist, insbesondere Kupfer.

Wenn mindestens ein erfindungsgemäßer Komplex als emittierende Verbindung in einer emittierenden Schicht eingesetzt wird, wird sie bevorzugt als Reinsubstanz oder in Kombination mit einem oder mehreren Matrixmaterialien eingesetzt. Die Mischung aus dem erfindungsgemäßen Komplex und dem Matrixmaterial enthält 1 bis 99 Gew.-%, vorzugsweise 2 bis 90 Gew.-%, besonders bevorzugt 3 bis 40 Gew.-%, insbesondere 5 bis 15 Gew.-% des erfindungsgemäßen Komplexes Verbind bezogen auf die Gesamtmischung aus Emitter und Matrixmaterial. Entsprechend enthält die Mischung 99 bis 1 Gew.-%, vorzugsweise 98 bis 10 Gew.-%, besonders bevorzugt 97 bis 60 Gew.-%, insbesondere 95 bis 85 Gew.-% des Matrixmaterials bezogen auf die Gesamtmischung aus Emitter und Matrixmaterial.

Bevorzugte Matrixmaterialien sind CBP (N,N-Biscarbazolylbiphenyl), Carbazolderivate (z. B. gemäß WO 05/039246 A, US 2005/0069729 A, JP 2004/288381 A, EP 1205527 oder der DE 102007002714 A1), Azacarbazole (z. B. gemäß EP 1617710 , EP 1617711 , EP 1731584 , JP 2005/347160), Ketone (z. B. gemäß WO 04/093207 A), Phosphinoxide, Sulfoxide und Sulfone (z. B. gemäß WO 05/003253), Oligophenylene, aromatische Amine (z. B. gemäß US 2005/0069729), bipolare Matrixmaterialien (z. B. gemäß WO 07/137725 A), Silane (z. B. gemäß WO 05/111172 A), 9,9-Diarylfluorenderivate (z. B. gemäß der DE 102008017591 A1), Azaborole oder Boronester (z. B. gemäß WO 06/117052 A). Weiterhin eignen sich als Matrixmaterialien die Verbindungen gemäß der Formel A der vorliegenden Anmeldung, wie unten ausgeführt.

In einer weiteren Ausführungsform der Erfindung wird der mindestens eine erfindungsgemäße Komplex als Matrixmaterial für eine emittierende Verbindung in einer emittierenden Schicht eingesetzt.

Wenn der erfindungsgemäße Metallkomplex als Matrixmaterial für eine emittierende Verbindung in einer emittierenden Schicht eingesetzt wird, wird er bevorzugt in Kombination mit einem oder mehreren lumineszierenden Materialien eingesetzt. Die Mischung aus der Verbindung gemäß Formel A und der emittierenden Verbindung enthält dann zwischen 99 und 1 Gew.-%, vorzugsweise zwischen 98 und 10 Gew.-%, besonders bevorzugt zwischen 97 und 60 Gew.-%, insbesondere zwischen 95 und 85 Gew.-% der Verbindung bezogen auf die Gesamtmischung aus Emitter und Matrixmaterial. Entsprechend enthält die Mischung zwischen 1 und 99 Gew.-%, vorzugsweise zwischen 2 und 90 Gew.-%, besonders bevorzugt zwischen 3 und 40 Gew.-%, insbesondere zwischen 5 und 15 Gew.-% des Emitters bezogen auf die Gesamtmischung aus Emitter und Matrixmaterial.

Als lumineszierende Verbindungen eignen sich insbesondere Verbindungen, die bei geeigneter Anregung Licht, vorzugsweise im sichtbaren Bereich, emittieren und außerdem mindestens ein Atom der Ordnungszahl grösser 20, bevorzugt grösser 38 und kleiner 84, besonders bevorzugt grösser 56 und kleiner 80 enthalten. Weiterhin eignen sich als Emitter die hier beschriebenen erfindungsgemäßen Metallkomplexe. Generell eignen sich alle lumineszierenden Komplexe, wie sie gemäß dem Stand der Technik für lumineszierende OLEDs verwendet werden und wie sie dem Fachmann auf dem Gebiet der organischen Elektrolumineszenz bekannt sind.

In einer weiteren Ausführungsform der Erfindung wird ein erfindungsgemäßer Metallkomplex als Lochblockiermaterial in einer Lochblockierschicht und/oder als Elektronentransportmaterial in einer Elektronentransportschicht eingesetzt. Dabei kann die emittierende Schicht fluoreszierend oder lumineszierend sein.

In einer Ausführungsform wird eine oder werden mehrere Schichten einer organische Elektrolumineszenzvorrichtung mit einem Sublimationsverfahren beschichtet. Dabei werden die Materialien in Vakuum-Sublimationsanlagen bei einem Druck kleiner 10⁻⁵ mbar, bevorzugt kleiner 10⁻⁶ mbar, besonders bevorzugt kleiner 10⁻⁷ mbar aufgedampft.

Bevorzugt ist ebenfalls eine organische Elektrolumineszenzvorrichtung, dadurch gekennzeichnet, dass eine oder mehrere Schichten mit dem OVPD (Organic Vapor Phase Deposition) Verfahren oder mit Hilfe einer Trägergassublimation beschichtet werden. Dabei werden die Materialien bei einem Druck zwischen 10⁻⁵ mbar und 1 bar aufgebracht. Ein Spezialfall dieses Verfahrens ist das OVJP (Organic Vapor Jet Printing) Verfahren, bei dem die Materialien direkt durch eine Düse aufgebracht und so strukturiert werden (z. B. M. S. Arnold et al., Appl. Phys. Lett. 2008, 92, 053301).

Weiterhin bevorzugt ist eine organische Elektrolumineszenzvorrichtung, bei der eine oder mehrere Schichten aus Lösung, wie z. B. durch Spincoating, oder mit einem beliebigen Druckverfahren, wie z. B. Siebdruck, Flexodruck oder Offsetdruck, besonders bevorzugt aber LITI (Light-Induced Thermal Imaging, Thermotransferdruck) oder Ink-Jet Druck (Tintenstrahldruck), hergestellt werden. Hierfür sind lösliche Verbindungen nötig, welche beispielsweise durch geeignete Substitution erhalten werden. Derartige chemische Verfahren zur Modifikation von Molekülen sind dem Fachmann bekannt und können von ihm ohne Probleme auf organische Elektrolumineszenzvorrichtungen enthaltend mindestens einen erfindungsgemäßen Metallkomplex angewandt werden.

Die erfindungsgemäßen organischen elektronischen Vorrichtungen, insbesondere organischen Elektrolumineszenzvorrichtungen, zeichnen sich durch folgende überraschende Vorteile gegenüber dem Stand der Technik aus:
1. Im Gegensatz zu vielen Metallkomplexen aus dem Stand der Technik, die der teilweisen oder vollständigen pyrolytischen Zersetzung bei Sublimation unterliegen, weisen die erfindungsgemäßen Verbindungen eine hohe thermische Stabilität auf.
2. Organische Elektrolumineszenzvorrichtungen aufweisend einen erfindungsgemäßen als emittierende Materialien zeigen eine exzellente Lebensdauer.
3. Es sind blau lumineszierende Komplexe zugänglich, welche eine tiefblaue Emissionsfarbe und bei Verwendung in organischen Elektrolumineszenzvorrichtungen eine hohe Lebensdauer aufweisen. Dies ist ein deutlicher Fortschritt gegenüber dem Stand der Technik, da bislang blau lumineszierende Vorrichtungen nur mit schlechten Farbkoordinaten und insbesondere einer sehr schlechten Lebensdauer zugänglich waren.
4. Die erfindungsgemäßen Metallkomplexe, eingesetzt in organischen Elektrolumineszenzvorrichtungen, führen zu hohen Effizienzen und zu steilen Strom-Spannungs-Kurven.

Diese oben genannten Vorteile gehen nicht mit einer Verschlechterung der weiteren elektronischen Eigenschaften einher.

Beispielhaft kommen folgende Liganden als Liganden L für die erfindungsgemäßen Metallkomplexe in Frage:

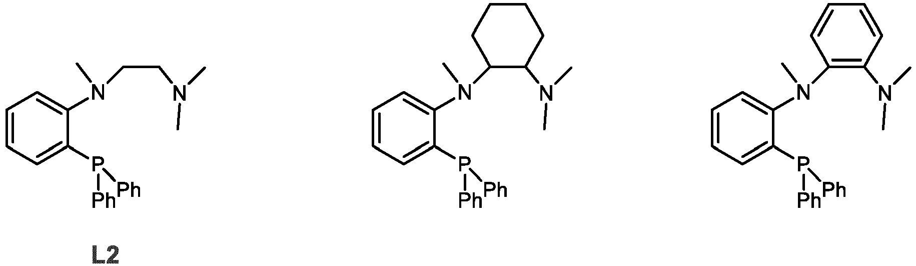

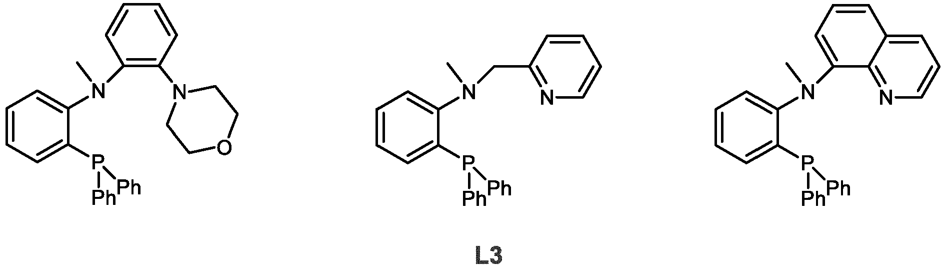

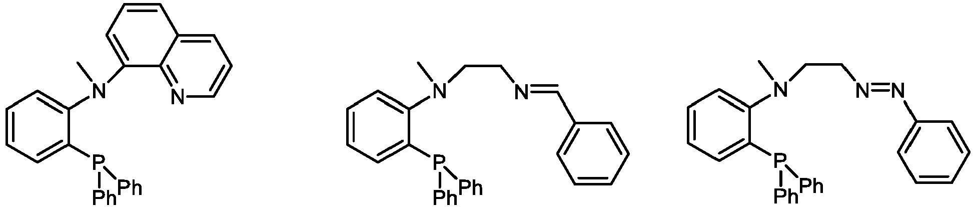

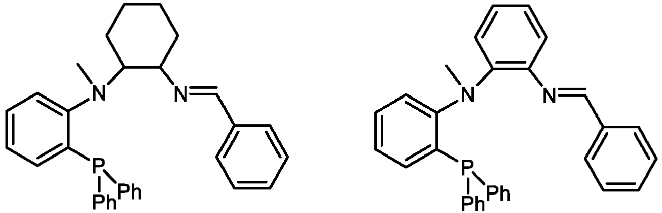

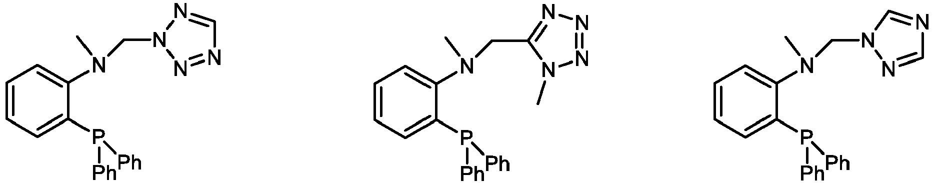

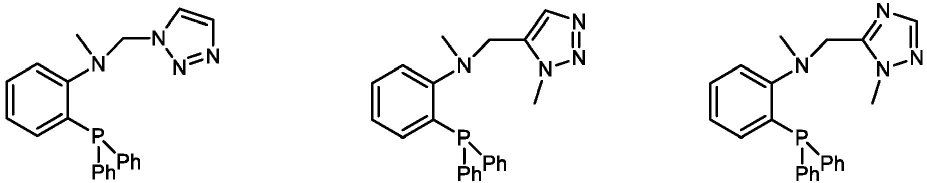

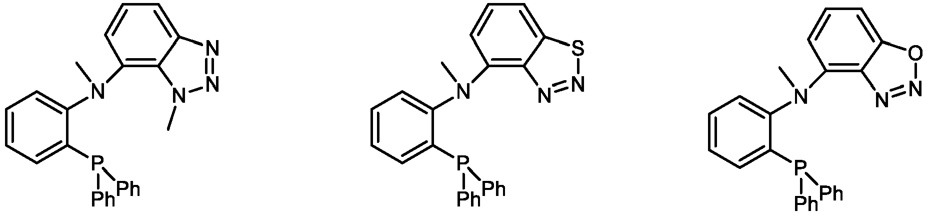

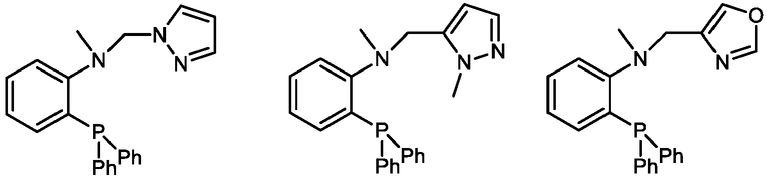

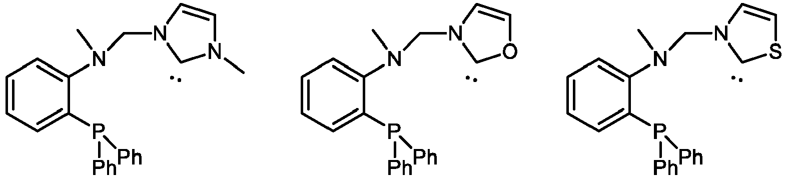

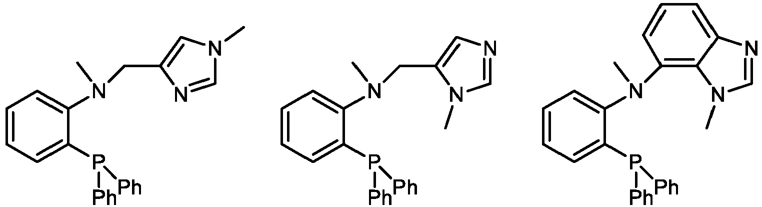

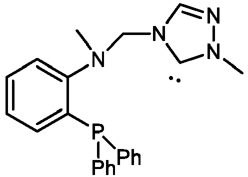

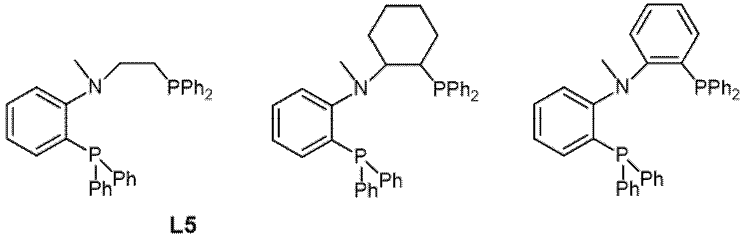

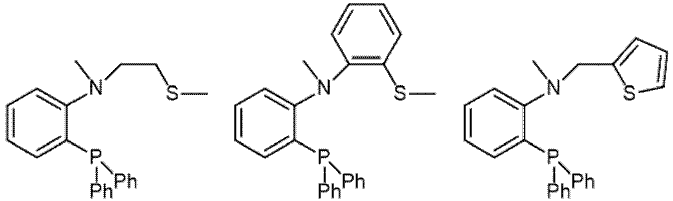

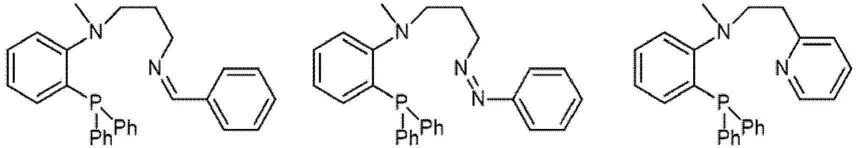

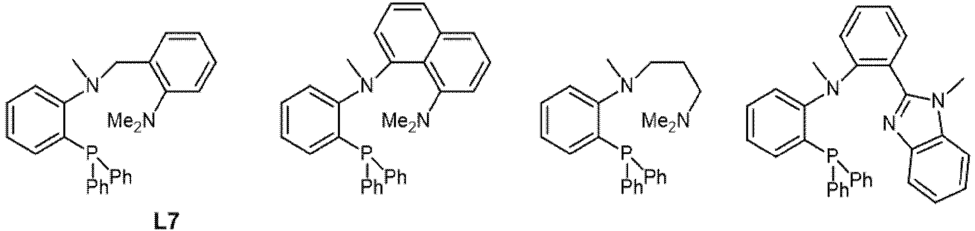

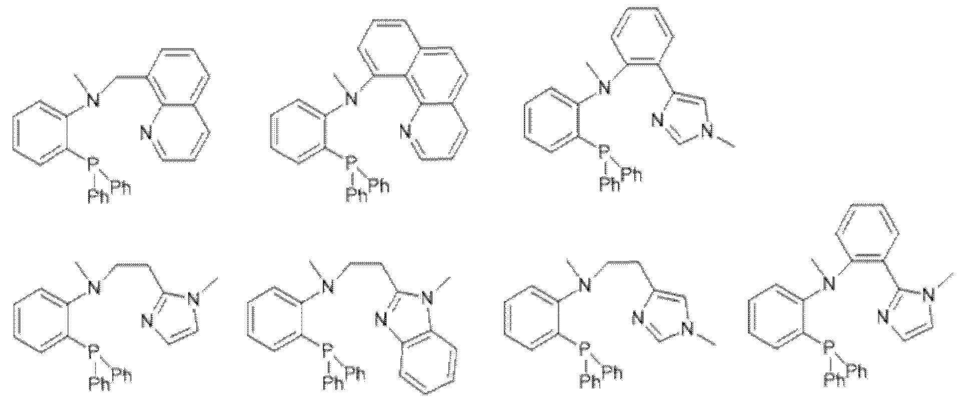

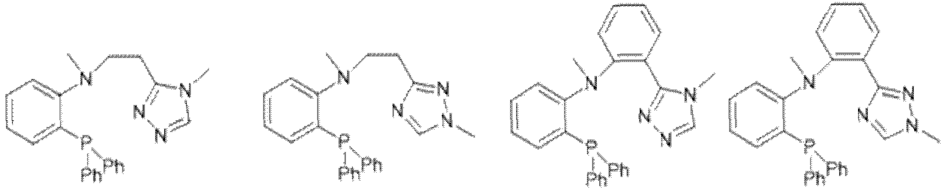

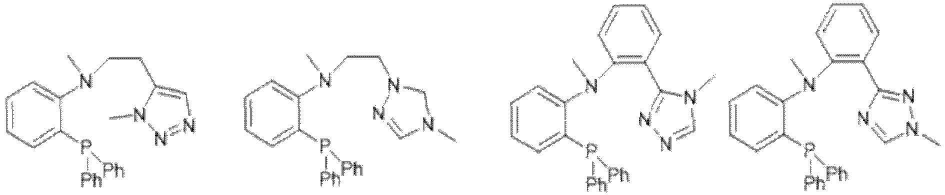

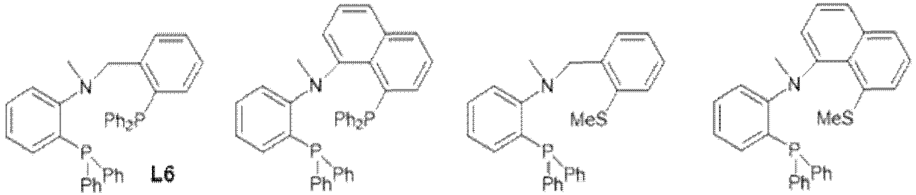

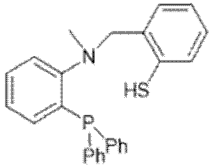

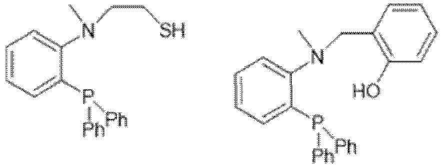

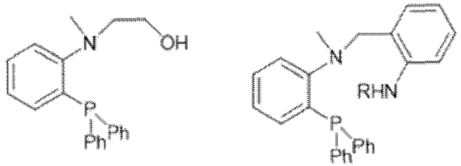

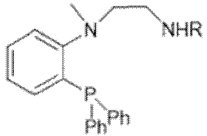

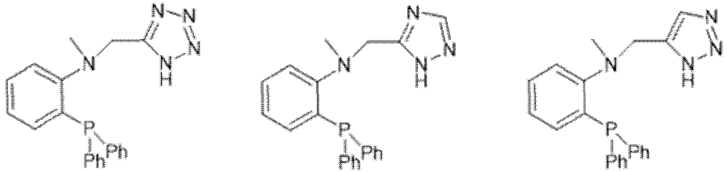

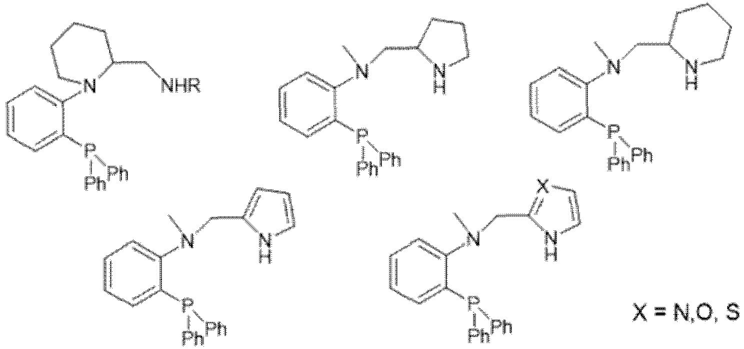

### Beispiele

Die Erfindung wird durch die nachfolgenden Beispiele näher erläutert, ohne sie dadurch einschränken zu wollen. Der Fachmann kann aus den Schilderungen ohne erfinderisches Zutun weitere erfindungsgemäße Komplexe herstellen und diese in organischen elektronischen Vorrichtungen verwenden bzw. das erfindungsgemäße Verfahren anwenden.

### Allgemeine Arbeitsvorschrift (AAV) zur Kupplung von Iod-Brombenzol mit Aminen (AAV1):

Unter Stickstoff werden Pd₂(dba)₃ (0.005 Äq), NaOtBu (1.4 Äq) und Xantphos (0.02 Äq) in trockenem Toluol vorgelegt und nacheinander die 2-Brom-1-iodbenzol (1 Äq) sowie das zu kuppelnde Amin (1.05 Äq) hinzu gegeben. Anschließend wird die Mischung unter Rückfluss bis zum vollständigen Umsatz (GC-Kontrolle) gerührt. Nachdem die Mischung auf RT gebracht wurde, wird das Lösungsmittel entfernt und der Rückstand in DCM/Wasser aufgenommen. Die organische Phase wird abgetrennt und aufbewahrt, während die wässrige Phase zweimal mit DCM extrahiert wird. Die vereinten organischen Phasen werden über Na₂SO₄ getrocknet und das Lösungsmittel abdestilliert. Der braune ölige Rückstand wird mittels Säulenchromatographie aufgereinigt. (CyHex/EE 15:1 -> 10:1 verwendet)

### Beispiel 1:

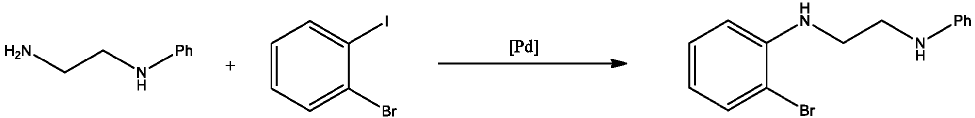

¹H-NMR (500 MHz, CDCl₃) δ = 7.50 (td, 1H), 7.26 (m, 3H), 6.82 (tt, 1H), 6.74 (ddd, 3H), 6.66 (td, 1H), 3.48 (s, 4H); NH nicht beobachtet; GC-MS (4min, 50-300 °C): 12.40 min (M⁺ = 291.19)

### AAV2 für Brom-Lithium-Austausch:

Das Arylbromid (1 Äq) wird in trockenem Ether vorgelegt und auf -78 °C (Trockeneis, Aceton) gekühlt. Anschließend wird 2.5 molares n-BuLi (1 Äq) langsam zugetropft und eine Stunde lang bei -78 °C gerührt. Nachdem die Lösung auf RT gebracht wurde, wird wieder auf -78 °C gekühlt und das entsprechende Phosphinchlorid (i.d.R. Ph₂PCl) langsam per Spritze zugegeben. Über Nacht wird die Lösung auftauen gelassen und die Reaktion durch vorsichtige Zugabe (Eisbadkühlung) von 1 molarer NaOH abgebrochen. Es kommt häufiger vor, dass die Phosphine nicht in Ether löslich sind und sich ein weißer Feststoff in der etherischen Phase befindet. Dieser wird nach der Abtrennung der etherischen Phase von der wässrigen durch Zugabe von DCM aufgelöst. Die wässrige Phase wird zweimal mit DCM extrahiert und die vereinigten organischen Phasen werden über Na₂SO₄ getrocknet, das Lösungsmittel im Vakuum entfernt. Der meist ölige Rückstand wird mittels Säulenchromatographie aufgereinigt. (CyHex/EE 20:1 -> 10:1)

### Beispiel 2:

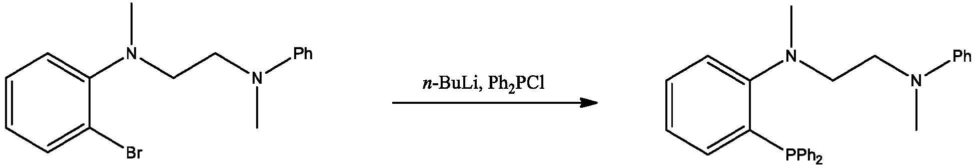

¹H NMR (500 MHz, CDCl₃) δ = 7.41-7.38 (m, 7H), 7.37-7.33 (m, 4H), 7.27 - 7.20 (m, 3H), 7.09 (td, 1H), 6.83 (ddd, 1H), 6.71 (t, 1H), 6.62 (d, 2H), 2.79 (s, 3H), 2.72 (s, 3H). ³¹P-NMR (125 MHz, CDCl₃) δ = -13.90; GC-MS (4min, 50-300°C): 17.87 min (M⁺ = 424.53)

### AAV3 Komplexsynthese:

Der Ligand wird zusammen mit dem Metallsalz (insbesondere Cul, CuBr oder CuCI) in ein Vial gegeben, welches verschlossen und evakuiert wird. Nachdem es mit Schutzgas beschickt wurde, wird Acetonitril hinzugefügt und über Nacht gerührt. Der entstandene Feststoff wird abfiltriert, mit wenig kaltem Acetonitril gewaschen und im Vakuum getrocknet.

### Beispiel 3a:

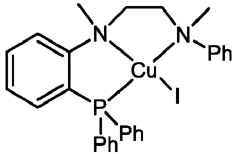

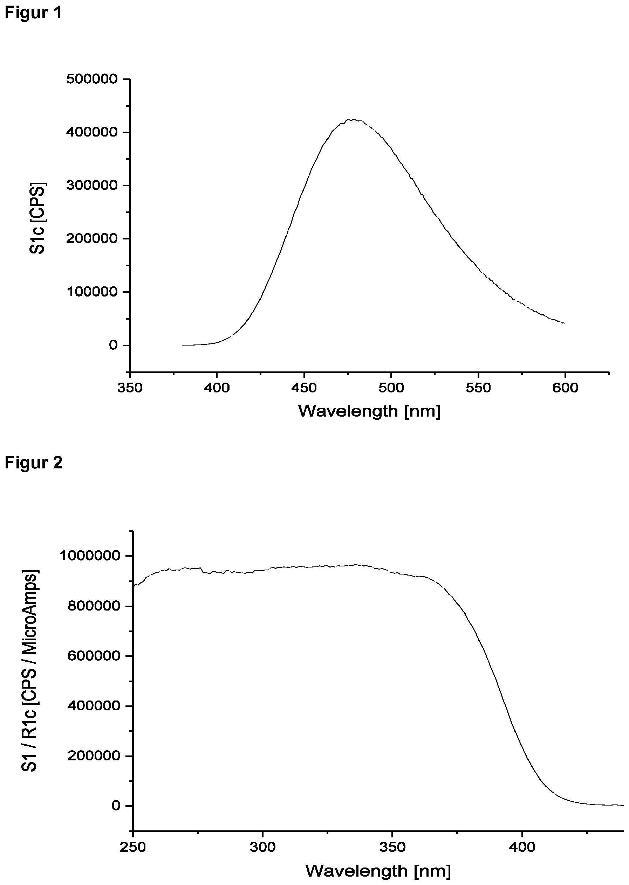

FAB-MS (m/z) = 614 M⁺;
Das Emissionsspektrum von 3a als Pulver bei Raumtemperatur ist in Figur 1 gezeigt.
Das Anregungsspektrum von 3a als Pulver bei Raumtemperatur ist in Figur 2 gezeigt.

### Beispiel 3b:

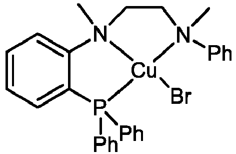

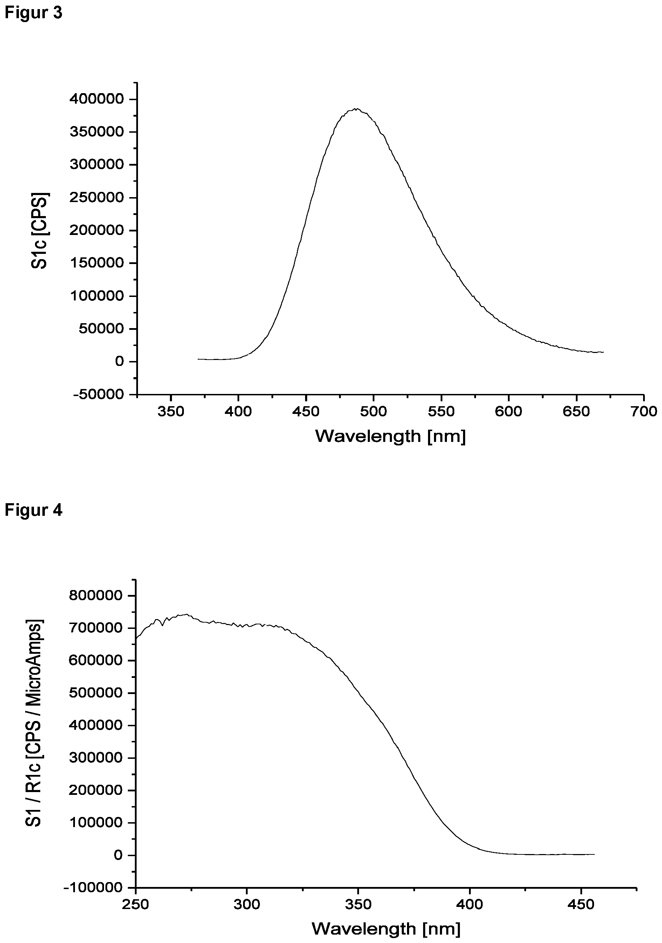

Das Emissionsspektrum von 3b als Pulver bei Raumtemperatur ist in Figur 3 gezeigt.
Das Anregungsspektrum von 3b als Pulver bei Raumtemperatur ist in Figur 4 gezeigt.

### Beispiel 3c:

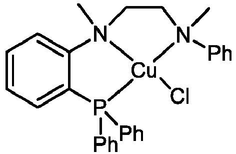

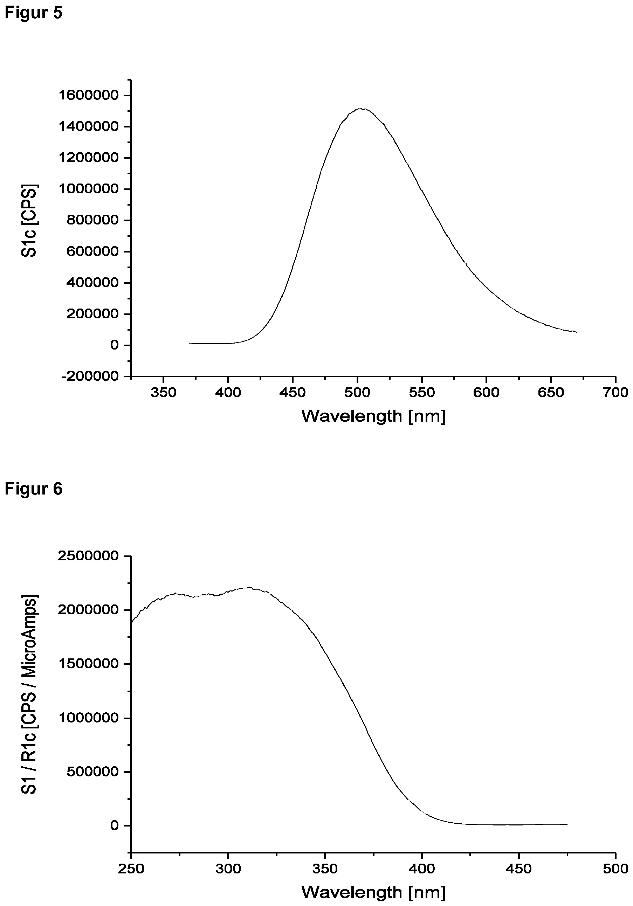

Berechnet C: 66,24 H: 5,58 N: 5,35; gefunden C: 64,36 H: 5,37 N: 5,69
Das Emissionsspektrum von 3c als Pulver bei Raumtemperatur ist in Figur 5 gezeigt.
Das Anregungsspektrum von 3c als Pulver bei Raumtemperatur ist in Figur 6 gezeigt.

### Beispiel 4: Herstellung und Charakterisierung von organischen Elektrolumineszenzvorrichtungen:

Die Herstellung von OLEDs erfolgt nach dem im Folgenden skizzierten allgemeinen Verfahren. Dieses muss natürlich im Einzelfall auf die jeweiligen Gegebenheiten (z. B. Schichtdickenvariation, um optimale Effizienz bzw. Farbe zu erreichen) angepasst werden.

### Allgemeines Verfahren zur Herstellung der OLEDs:

Nachdem man die ITO-beschichteten Substrate (z. B. Glasträger, PET-Folie) auf die richtige Größe zugeschnitten hat, werden sie in mehreren Reinigungsschritten im Ultraschallbad gereinigt (z. B. Seifenlösung, Millipore-Wasser, Isopropanol). Zur Trocknung werden sie mit einer N2-Pistole abgepustet und in einem Exsikkator gelagert. Vor der Bedampfung mit den organischen Schichten werden sie mit einem Ozon-Plasma-Gerät für ca. 20 Minuten behandelt. Es kann sich empfehlen, als erste organische Schicht eine polymere Lochinjektionsschicht zu verwenden. Dies ist in der Regel ein konjugiertes, leitfähiges Polymer, wie z. B. ein Polyanilinderivat (PANI) oder eine Polythiophenderivat (z. B. PEDOT, BAYTRON P® von BAYER). Diese wird dann durch Spin-Coaten (Lackschleudern) aufgebracht. Die organischen Schichten werden der Reihe nach durch Aufdampfen in einer Hochvakuumanlage aufgebracht. Dabei werden die Schichtdicke der jeweiligen Schicht und die Bedampfungsrate über einen Schwingquarz verfolgt bzw. eingestellt. Es können auch einzelne Schichten aus mehr als einer Verbindung bestehen, d. h. in der Regel ein Wirtsmaterial (host) mit einem Gastmaterial (guest) dotiert sein. Dies wird durch Co-Verdampfung aus zwei bzw. mehreren Quellen erzielt. Auf die organischen Schichten wird noch eine Elektrode aufgebracht. Dies geschieht in der Regel durch thermisches Verdampfen (Balzer BA360 bzw. Pfeiffer PL S 500). Anschließend wird die durchsichtige ITO-Elektrode als Anode und die Metallelektrode als Kathode kontaktiert, und es werden die Device-Parameter bestimmt.

Es wurden OLEDs mit folgendem Schichtaufbau hergestellt:
ITO 120 nm / CuPc 10 nm / NBPhen: α-NPD (1:2) 10 nm / NBPhen : Emitter (3:7) 50 nm / TPBI 50 nm / LiF 1 nm / Al 80 nm. ITO: Indiumzinnoxid; CuPc: Kupferphthalocyanin;
NBPhen: 2,9-Bis(naphtalen-2-yl)-4,7-diphenyl-1,10-phenanthrolin; TPBI: 2,2',2"-(1,3,5-Benzinetriyl)-tris(1-phenyl-1-H-benzimidazol).

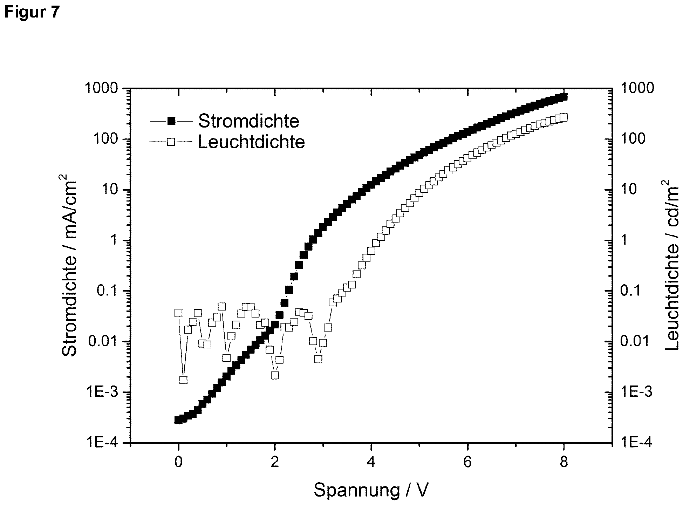

Als Emitter wurde der Kupferkomplex gemäß Beispiel 3a genutzt. Figur 7 zeigt den Strom-Spannungs-Verlauf und den Leuchtdichte-Spannungs-Verlauf der OLED im Betrieb.

### Figuren

- Figur 1:: Emissionsspektrum von 3a als Pulver bei Raumtemperatur; Anregungswellenlänge: 350 nm.
- Figur 2:: Anregungsspektrum von 3a als Pulver bei Raumtemperatur.
- Figur 3:: Emissionsspektrum von 3b als Pulver bei Raumtemperatur; Anregungswellenlänge: 350 nm.
- Figur 4:: Anregungsspektrum von 3b als Pulver bei Raumtemperatur.
- Figur 5:: Emissionsspektrum von 3c als Pulver bei Raumtemperatur; Anregungswellenlänge: 350 nm.
- Figur 6:: Anregungsspektrum von 3c als Pulver bei Raumtemperatur.
- Figur 7:: Strom-Spannungskurve und Leuchtdichte-Spannungs-Kurve einer OLED mit Emitter gemäß Beispiel 3a.

## Patentansprüche

1. Metallkomplex, aufweisend eine Struktur der Formel A-3 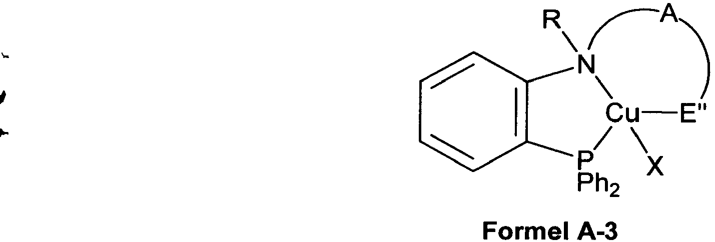 mit
A = Brücke mit mehr als einem und weniger als sechs (bezogen auf die kürzeste Kettenlänge) gleichen oder verschiedenen Kettengliedern k, bevorzugt mehr als ein und weniger als 4, stärker bevorzugt mehr als ein und weniger als 3, wobei k = C(sp²)R, CR₂, C=O, C=S, C=NR, O, N, NR, S, Se; wobei optional eine oder mehrere Glieder von k auch Teil eines aromatischen oder aliphatischen Ringsystems wie bei C(sp²) definiert sind;
E" = entweder eine chemisch neutrale Gruppe ausgewählt aus C*R (Carben-Kohlenstoff), NR (Imin-Stickstoff), NR₂, PR₂, AsR₂, OR, SR, SeR, optional als Teil eines neutralen aromatischen oder heteroaromatischen Ringsystems wie bei C(sp²) definiert oder eine einfach negativ geladene Gruppe ausgewählt aus NR, PR, AsR, O, S, Se, optional als Teil eines anionischen heteroaromatischen Ringsystems wie bei C(sp²) definiert;
X = ausgewählt aus der Gruppe bestehend aus Cl, Br, I, CN, OCN, SCN, Alkinyl und N₃; wobei X nur vorhanden ist bei E" = eine chemisch neutrale Gruppe;
R ist bei jedem Auftreten unabhängig voneinander ausgewählt aus der Gruppe bestehend aus H, Deuterium, Phenyl, Naphthyl, F, Cl, Br, I, N(R²)₂, -CN, -NC, -SCN, - CF₃, -NO₂, -OH, C(=O)OH, C(=O)OR³, C(=O)N(R³)₂, C(=O)SR³, C(=S)SR³, Si(R⁴)₃, B(OR⁵)₂, B(N(R⁶)₂)₂, C(=O)R³, P(=O)(R⁷)₂, As(=O)(R⁷)₂, P(=S)(R⁷)₂, As(=S)(R⁷)₂, S(=O)R³, S=NR³, S(=O)NR³, S(=O)₂NR³, S(=O)₂R³, O-S(=O)₂R³, SFs, eine lineare Alkyl-, Alkoxy- oder Thioalkoxygruppe mit 1 bis 40 C-Atomen oder eine lineare Alkenyl- oder Alkinylgruppe mit 2 bis 40 C-Atomen oder eine verzweigte oder cyclische Alkyl-, Alkenyl-, Alkinyl-, Alkoxy- oder Thioalkoxygruppe mit 3 bis 40 C-Atomen, die jeweils mit einem oder mehreren Resten R⁹ substituiert sein kann, wobei eine oder mehrere benachbarte CH₂-Gruppen durch -R⁹C=CR⁹-, -C=C-, bzw. eine benachbarte CH₂-Gruppe durch -Si(R⁴)₂-, -Ge(R⁴)₂-, -Sn(R⁴)₂, -C(=O)-, -C(=S)-, -C(=Se)-, -C=N-, - C(=O)O-, -C(=O)N(R³)-, -P(=O)(R⁷)-, -As(=O)(R⁷)-, -P(=S)(R⁷)-, -As(=S)(R⁷)-, -S(=O)-, -S(=O)₂-, -NR²-, -O-, oder -S- ersetzt sein können und wobei ein oder mehrere H-Atome durch Deuterium, F, Cl, Br, I, CN, CF₃ oder NO₂ ersetzt sein können, oder ein aromatisches oder heteroaromatisches Ringsystem mit 5 bis 60 aromatischen Ringatomen, das jeweils durch einen oder mehrere Reste R² substituiert sein kann, oder eine Aryloxy- oder Heteroaryloxygruppe mit 5 bis 60 aromatischen Ringatomen, die durch einen oder mehrere Reste R⁹ substituiert sein kann, oder eine Diarylaminogruppe, Diheteroarylaminogruppe oder Arylheteroarylaminogruppe mit 10 bis 40 aromatischen Ringatomen, welche durch einen oder mehrere Reste R⁹ substituiert sein kann, oder eine Kombination dieser Systeme; dabei können zwei oder mehrere dieser Substituenten R auch miteinander ein monozyklisches aliphatisches Ringsystem mit insgesamt fünf oder sechs Ringgliedern bilden;
R² ist bei jedem Auftreten unabhängig voneinander ausgewählt aus der Gruppe bestehend aus H, Deuterium, Phenyl, Naphthyl, CF₃, C(=O)OR³, Si(R⁴)₃, C(=O)R³, P(=O)(R⁷)₂, As(=O)(R⁷)₂ P(=S)(R⁷)₂, As(=S)(R⁷)₂, S(=O)R³, S(=O)₂R³, eine lineare Alkyl-, Alkoxy- oder Thioalkoxygruppe mit 1 bis 40 C-Atomen oder eine lineare Alkenyl- oder Alkinylgruppe mit 2 bis 40 C-Atomen oder eine verzweigte oder cyclische Alkyl-, Alkenyl-, Alkinyl-, Alkoxy- oder Thioalkoxygruppe mit 3 bis 40 C-Atomen, die jeweils mit einem oder mehreren Resten R⁹ substituiert sein kann, wobei eine oder mehrere benachbarte CH₂-Gruppen durch -R⁹C=CR⁹-, -C=C-, bzw. eine benachbarte CH₂-Gruppe durch -Si(R⁴)₂-, -Ge(R⁴)₂-, -Sn(R⁴)₂, -C(=O)-, -C(=S)-, -C(=Se)-, -C=N-, - C(=O)O-, -C(=O)N(R³)-, -P(=O)(R⁷)-, -As(=O)(R⁷)-, -P(=S)(R⁷)-, -As(=S)(R⁷)-, -S(=O)-, -S(=O)₂-, -O-, oder -S-ersetzt sein können und wobei ein oder mehrere H-Atome durch Deuterium, F, Cl, Br, I, CN, CF₃ oder NO₂ ersetzt sein können, oder ein aromatisches oder heteroaromatisches Ringsystem mit 5 bis 60 aromatischen Ringatomen, das jeweils durch einen oder mehrere Reste R⁹ substituiert sein kann, oder eine Aryloxy- oder Heteroaryloxygruppe mit 5 bis 60 aromatischen Ringatomen, die durch einen oder mehrere Reste R⁹ substituiert sein kann, oder eine Diarylaminogruppe, Diheteroarylaminogruppe oder Arylheteroarylaminogruppe mit 10 bis 40 aromatischen Ringatomen, welche durch einen oder mehrere Reste R⁹ substituiert sein kann, oder eine Kombination dieser Systeme; dabei können zwei oder mehrere dieser Substituenten R² auch miteinander ein mono- oder polycyclisches, aliphatisches, aromatisches und/oder benzoannelliertes Ringsystem bilden;
R³ ist bei jedem Auftreten unabhängig voneinander ausgewählt aus der Gruppe bestehend aus H, Deuterium, Phenyl, Naphthyl, CF₃ oder ein aliphatischer, aromatischer und/oder heteroaromatischer Kohlenwasserstoffrest mit 1 bis 20 C-Atomen, in dem auch ein oder mehrere H-Atome durch F oder CF₃ ersetzt sein können; dabei können zwei oder mehrere Substituenten R³ auch miteinander ein mono- oder polycyclisches, aliphatisches Ringsystem bilden;
R⁴ ist bei jedem Auftreten unabhängig voneinander ausgewählt aus der Gruppe bestehend aus H, Deuterium, Phenyl, Naphthyl, CN, CF₃, OH, C(=O)OR³, C(=O)N(R³)₂, C(=O)R³, P(=O)(R⁷)₂, As(=O)(R⁷)₂, P(=S)(R⁷)₂, As(=S)(R⁷)₂, eine lineare Alkyl-, Alkoxy- oder Thioalkoxygruppe mit 1 bis 40 C-Atomen oder eine lineare Alkenyl- oder Alkinylgruppe mit 2 bis 40 C-Atomen oder eine verzweigte oder cyclische Alkyl-, Alkenyl-, Alkinyl-, Alkoxy- oder Thioalkoxygruppe mit 3 bis 40 C-Atomen, die jeweils mit einem oder mehreren Resten R⁹ substituiert sein kann, wobei eine oder mehrere benachbarte CH₂-Gruppen durch -R⁹C=CR⁹-, -C=C-, bzw. eine benachbarte CH₂-Gruppe durch -C(=O)-, -C(=S)-, -C(=Se)-, -C=N-, -C(=O)O-, -C(=O)N(R³)-, -P(=O)(R⁷)-, -As(=O)(R⁷)-, -P(=S)(R⁷)-, -As(=S)(R⁷)-, -S(=O)-, -S(=O)₂-, -O-, oder -S- ersetzt sein können und wobei ein oder mehrere H-Atome durch Deuterium, F, Cl, Br, I, CN, CF₃ oder NO₂ ersetzt sein können, oder ein aromatisches oder heteroaromatisches Ringsystem mit 5 bis 60 aromatischen Ringatomen, das jeweils durch einen oder mehrere Reste R⁸ substituiert sein kann, oder eine Aryloxy- oder Heteroaryloxygruppe mit 5 bis 60 aromatischen Ringatomen, die durch einen oder mehrere Reste R⁹ substituiert sein kann, oder eine Diarylaminogruppe, Diheteroarylaminogruppe oder Arylheteroarylaminogruppe mit 10 bis 40 aromatischen Ringatomen, welche durch einen oder mehrere Reste R⁹ substituiert sein kann, oder eine Kombination dieser Systeme; dabei können zwei oder mehrere dieser Substituenten R⁴ auch miteinander ein mono- oder polycyclisches, aliphatisches, aromatisches und/oder benzoannelliertes Ringsystem bilden;
R⁵ ist bei jedem Auftreten unabhängig voneinander ausgewählt aus der Gruppe bestehend aus Phenyl, Naphthyl, CF₃, C(=O)R³, P(=O)(R⁷)₂, As(=O)(R⁷)₂, eine lineare Alkyl-, Alkoxy- oder Thioalkoxygruppe mit 1 bis 40 C-Atomen oder eine lineare Alkenyl- oder Alkinylgruppe mit 2 bis 40 C-Atomen oder eine verzweigte oder cyclische Alkyl-, Alkenyl-, Alkinyl-, Alkoxy- oder Thioalkoxygruppe mit 3 bis 40 C-Atomen, die jeweils mit einem oder mehreren Resten R⁹ substituiert sein kann, wobei eine oder mehrere benachbarte CH₂-Gruppen durch -R⁹C=CR⁹-, -C=C-, bzw. eine benachbarte CH₂-Gruppe durch -Si(R⁴)₂-, -Ge(R⁴)₂-, -Sn(R⁴)₂, -C(=O)-, -C(=S)-, -C(=Se)-, -C=N-, - C(=O)O-, -C(=O)N(R³)-, -P(=O)(R⁷)-, -As(=O)(R⁷)-, -P(=S)(R⁷)-, -As(=S)(R⁷)-, -S(=O)-, -S(=O)₂-, -NR²-, -O-, oder -S- ersetzt sein können und wobei ein oder mehrere H-Atome durch Deuterium, F, Cl, Br, I, CN, CF₃ oder NO₂ ersetzt sein können, oder ein aromatisches oder heteroaromatisches Ringsystem mit 5 bis 60 aromatischen Ringatomen, das jeweils durch einen oder mehrere Reste R⁹ substituiert sein kann, oder eine Aryloxy- oder Heteroaryloxygruppe mit 5 bis 60 aromatischen Ringatomen, die durch einen oder mehrere Reste R⁹ substituiert sein kann, oder eine Diarylaminogruppe, Diheteroarylaminogruppe oder Arylheteroarylaminogruppe mit 10 bis 40 aromatischen Ringatomen, welche durch einen oder mehrere Reste R⁹ substituiert sein kann, oder eine Kombination dieser Systeme; dabei können zwei oder mehrere dieser Substituenten R⁵ auch miteinander ein mono- oder polycyclisches, aliphatisches, aromatisches und/oder benzoannelliertes Ringsystem bilden;
R⁶ ist bei jedem Auftreten unabhängig voneinander ausgewählt aus der Gruppe bestehend aus Phenyl, Naphthyl, CF₃, Si(R⁴)₃, C(=O)R³, P(=O)(R⁷)₂, eine lineare Alkyl- , Alkoxy- oder Thioalkoxygruppe mit 1 bis 40 C-Atomen oder eine lineare Alkenyl- oder Alkinylgruppe mit 2 bis 40 C-Atomen oder eine verzweigte oder cyclische Alkyl-, Alkenyl-, Alkinyl-, Alkoxy- oder Thioalkoxygruppe mit 3 bis 40 C-Atomen, die jeweils mit einem oder mehreren Resten R⁹ substituiert sein kann, wobei eine oder mehrere benachbarte CH₂-Gruppen durch -R⁹C=CR⁹-, -C=C-, bzw. eine benachbarte CH₂-Gruppe durch-Si(R⁴)₂-, -Ge(R⁴)₂-, -Sn(R⁴)₂, -C(=O)-, -C(=S)-, -C(=Se)-, -C=N-, - C(=O)O-, -C(=O)N(R³)-, -P(=O)(R⁷)-, -As(=O)(R⁷)-, -P(=S)(R⁷)-, -As(=S)(R⁷)-, -S(=O)-, -S(=O)₂-, -NR²-, -O-, oder -S- ersetzt sein können und wobei ein oder mehrere H-Atome durch Deuterium, F, Cl, Br, I, CN, CF₃ oder NO₂ ersetzt sein können, oder ein aromatisches oder heteroaromatisches Ringsystem mit 5 bis 60 aromatischen Ringatomen, das jeweils durch einen oder mehrere Reste R⁹ substituiert sein kann, oder eine Aryloxy- oder Heteroaryloxygruppe mit 5 bis 60 aromatischen Ringatomen, die durch einen oder mehrere Reste R substituiert sein kann, oder eine Diarylaminogruppe, Diheteroarylaminogruppe oder Arylheteroarylaminogruppe mit 10 bis 40 aromatischen Ringatomen, welche durch einen oder mehrere Reste R⁹ substituiert sein kann, oder eine Kombination dieser Systeme; dabei können zwei oder mehrere dieser Substituenten R⁶ auch miteinander ein mono- oder polycyclisches, aliphatisches, aromatisches und/oder benzoannelliertes Ringsystem bilden;
R⁷ ist bei jedem Auftreten unabhängig voneinander ausgewählt aus der Gruppe bestehend aus Phenyl, Naphthyl, CN, CF₃, C(=O)OR³, C(=O)N(R³)₂, C(=O)R³, eine lineare Alkyl-, Alkoxy- oder Thioalkoxygruppe mit 1 bis 40 C-Atomen oder eine lineare Alkenyl- oder Alkinylgruppe mit 2 bis 40 C-Atomen oder eine verzweigte oder cyclische Alkyl-, Alkenyl-, Alkinyl-, Alkoxy- oder Thioalkoxygruppe mit 3 bis 40 C-Atomen, die jeweils mit einem oder mehreren Resten R⁹ substituiert sein kann, wobei eine oder mehrere benachbarte CH₂-Gruppen durch -R⁹C=CR⁹-, -C=C-, bzw. eine benachbarte CH₂-Gruppe durch -C(=O)-, -C(=S)-, -C(=Se)-, -C=N-, -C(=O)O-, -C(=O)N(R³)-, - S(=O)-, -S(=O)₂-, -O-, oder -S- ersetzt sein können und wobei ein oder mehrere H-Atome durch Deuterium, F, Cl, Br, I, CN, CF₃ oder NO₂ ersetzt sein können, oder ein aromatisches oder heteroaromatisches Ringsystem mit 5 bis 60 aromatischen Ringatomen, das jeweils durch einen oder mehrere Reste R⁹ substituiert sein kann, oder eine Aryloxy- oder Heteroaryloxygruppe mit 5 bis 60 aromatischen Ringatomen, die durch einen oder mehrere Reste R⁹ substituiert sein kann, oder eine Diarylaminogruppe, Diheteroarylaminogruppe oder Arylheteroarylaminogruppe mit 10 bis 40 aromatischen Ringatomen, welche durch einen oder mehrere Reste R³ substituiert sein kann, oder eine Kombination dieser Systeme; dabei können zwei oder mehrere dieser Substituenten R⁷ auch miteinander ein mono- oder polycyclisches, aliphatisches, aromatisches und/oder benzoannelliertes Ringsystem bilden;
R⁸ ist bei jedem Auftreten unabhängig voneinander ausgewählt aus der Gruppe bestehend aus H, Deuterium, Phenyl, Naphthyl, F, CF₃ oder ein aliphatischer, aromatischer und/oder heteroaromatischer Kohlenwasserstoffrest mit 1 bis 20 C-Atomen, in dem auch ein oder mehrere H-Atome durch F oder CF₃ ersetzt sein können; dabei können zwei oder mehrere Substituenten R⁸ auch miteinander ein mono- oder polycyclisches, aliphatisches Ringsystem bilden;
R⁹ ist bei jedem Auftreten unabhängig voneinander ausgewählt aus der Gruppe bestehend aus H, Deuterium, Phenyl, Naphthyl, CN, CF₃, NO₂, OH, COOH, C(=O)OR³, C(=O)N(R³)₂, C(=O)R³, S(=O)R³, S(=O)₂R³, OSO₂R³, eine lineare Alkyl-, Alkoxy- oder Thioalkoxygruppe mit 1 bis 40 C-Atomen oder eine lineare Alkenyl- oder Alkinylgruppe mit 2 bis 40 C-Atomen oder eine verzweigte oder cyclische Alkyl-, Alkenyl-, Alkinyl-, Alkoxy- oder Thioalkoxygruppe mit 3 bis 40 C-Atomen, die jeweils " mit einem oder mehreren Resten R⁸ substituiert sein kann, wobei eine oder mehrere nicht benachbarte CH₂-Gruppen durch -R³C=CR³-, -C=C-, bzw. eine benachbarte CH₂-Gruppe durch -C(=O)-, -C(=S)-, -C(=Se)-, -C=N-, -C(=O)O-, -C(=O)N(R³)-, - S(=O)-, -S(=O)₂-, -O-, oder -S- ersetzt sein können und wobei ein oder mehrere H-Atome durch Deuterium, F, Cl, Br, I, CN, CF₃ oder NO₂ ersetzt sein können, oder ein aromatisches oder heteroaromatisches Ringsystem mit 5 bis 60 aromatischen Ringatomen, das jeweils durch einen oder mehrere Reste R⁸ substituiert sein kann, oder eine Aryloxy- oder Heteroaryloxygruppe mit 5 bis 60 aromatischen Ringatomen, die durch einen oder mehrere Reste R³ substituiert sein kann, oder eine Diarylaminogruppe, Diheteroarylaminogruppe oder Arylheteroarylaminogruppe mit 10 bis 40 aromatischen Ringatomen, welche durch einen oder mehrere Reste R⁸ substituiert sein kann, oder eine Kombination dieser Systeme; dabei können zwei oder mehrere dieser Substituenten R⁹ auch miteinander ein mono- oder polycyclisches, aliphatisches, aromatisches und/oder benzoannelliertes Ringsystem bilden.

2. Verwendung eines Metallkomplexes nach Anspruch 1 als Emitter oder Absorber und/oder Matrixmaterial und/oder Lochblockiermaterial und/oder als Elektronentransportmaterial in einem optoelektronischen Bauelement.

3. Verwendung nach Anspruch 2, wobei das optoelektronische Bauelement ausgewählt ist aus der Gruppe bestehend aus:
- organischen Elektrolumineszenzvorrichtungen (organische Leuchtdioden, OLEDs, PLEDs),
- organischen integrierten Schaltungen (O-ICs),
- lichtemittierenden elektrochemischen Zellen (LECs),
- organischen Solarzellen (O-SCs),
- organischen Feldeffekttransistoren(O-FETs),
- organischen Dünnfilmtransistoren (O-TFTs),
- organischen lichtemittierenden Transistoren (O-LETs),
- OLED-Sensoren, insbesondere in nicht hermetisch nach außen abgeschirmten Gas- und Dampf-Sensoren,
- organischen optischen Detektoren,
- organischen Photorezeptoren,
- organischen Feld-Quench-Devices (O-FQDs) und
- organische Laserdioden (O-Laser).

4. Verwendung nach Anspruch 2 oder 3, **dadurch gekennzeichnet, dass** der Anteil des Metallkomplexes am Emitter oder Absorber 100 % beträgt.

5. Verwendung nach Anspruch 2 oder 3, **dadurch gekennzeichnet, dass** der Anteil des Metallkomplexes am Emitter oder Absorber 1 bis 99 Gew.-%, vorzugsweise 2 bis 90 Gew.-%, besonders bevorzugt 3 bis 40 Gew.-%, insbesondere 5 bis 15 Gew.-% bezogen auf die Gesamtmischung aus Emitter und Matrixmaterial beträgt.

6. Verwendung nach Anspruch 2 oder 3, **dadurch gekennzeichnet, dass** der Anteil des Metallkomplexes am Matrixmaterial 99 bis 1 Gew.-%, vorzugsweise 98 bis 10 Gew.-%, besonders bevorzugt 97 bis 60 Gew.-%, insbesondere 95 bis 85 Gew.-% bezogen auf die Gesamtmischung aus Emitter und Matrixmaterial beträgt.

7. Optoelektronisches Bauelement, aufweisend einen Metallkomplexe nach Anspruch 1.

8. Optoelektronisches Bauelement nach Anspruch 7, ausgeformt als ein Bauelement ausgewählt aus der Gruppe bestehend aus organischer Elektrolumineszenzverbindung, organisch integrierter Schaltung, lichtemittierender elektrochemischer Zelle, organischer Solarzelle, organischem Feldeffekttransistor, organischem Dünnfilmtransistor, organischen lichtemittierenden Transistoren, OLED-Sensoren, insbesondere in nicht hermetisch nach außen abgeschirmten Gas- und Dampf-Sensoren, organischen optischen Detektoren, organischen Photorezeptoren, organischen Feld-Quench-Devices und organische Laserdioden.

9. Verfahren zur Herstellung eines optoelektronischen Bauelements, wobei ein Metallkomplex nach Anspruch 1 verwendet wird.

10. Verfahren nach Anspruch 9, **gekennzeichnet durch** Aufbringen eines Metallkomplexes nach Anspruch 1 auf einen Träger.

11. Verfahren nach Anspruch 8, **dadurch gekennzeichnet, dass** das Aufbringen nass-chemisch, mittels kolloidaler Suspension oder mittels Sublimation erfolgt.

12. Verfahren nach Anspruch 10 oder 11, wobei eine oder mehrere Schichten mit einem Sublimationsverfahren beschichtet werden und wobei die Materialien in Vakuum-Sublimationsanlagen bei einem Druck kleiner 10⁻⁵ mbar, bevorzugt kleiner 10⁻⁶ mbar, besonders bevorzugt kleiner 10⁻⁷ mbar aufgedampft werden.

## Claims

1. Metal complex, comprising a structure of formula A-3 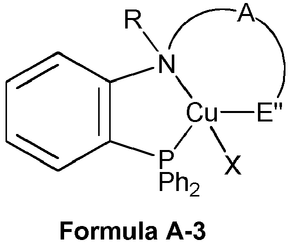 with
A = bridge with more than one and less than six (relating to the shortest chain length) identical or different chain members k, preferred more than one and less than 4, more preferred more than one and less than 3, wherein k = C(sp²)R, CR₂, C=O, C=S, C=NR, O, N, NR, S, Se; wherein optionally one or more members of k are part of an aromatic or aliphatic ring system as defined at C(sp²);
E" = either a chemically neutral group selected from C*R (carbene-carbon), NR (iminenitrogen), NR₂, PR₂, AsR₂, OR, SR, SeR, optionally as part of a neutral aromatic or heteroaromatic ring system as defined at C(sp²) or a single negatively charged group selected from NR, PR, AsR, O, S, Se, optionally as part of an anionic heteroaromatic ring system as defined at C(sp²);
X = selected from the group consistent of Cl, Br, I, CN, OCN, SCN, alkynyl and N₃; wherein X is only present during E" = a chemically neutral group;
R is at each instance independently of each other selected from the group consistent of H, deuterium, phenyl, naphthyl, F, Cl, Br, I, N(R²)₂, -CN, -NC, -SCN, -CF₃, -NO₂, - OH, C(=O)OH, C(=O)OR³, C(=O)N(R³)₂, C(=O)SR³, C(=S)SR³, Si(R⁴)₃, B(OR⁵)₂, B(N(R⁶)₂)₂, C(=O)R³, P(=O)(R⁷)₂, As(=O)(R⁷)₂, P(=S)(R⁷)₂, As(=S)(R⁷)₂, S(=O)R³, S=NR³, S(=O)NR³, S(=O)₂NR³, S(=O)₂R³, O-S(=O)₂R³, SF₅, a linear alkyl, alkoxy or thioalkoxy group having 1 to 40 carbon atoms or a linear alkenyl or alkynyl group having 2 to 40 carbon atoms or a branched or cyclic alkyl, alkenyl, alkynyl or thioalkoxy group having 3 to 40 carbon atoms, each of which may be substituted by one or more R⁹ moieties,
where one or more adjacent CH₂ groups may be replaced by -R⁹C=CR⁹-, -C=C- and one adjacent CH₂ group may be replaced by -Si(R⁴)₂-, -Ge(R⁴)₂-, -Sn(R⁴)₂, -C(=O)-, - C(=S)-, -C(=Se)-, -C=N-, -C(=O)O-, -C(=O)N(R³)-, -P(=O)(R⁷)-, -As(=O)(R⁷)-, - P(=S)(R⁷)-, -As(=S)(R⁷)-, -S(=O)-, -S(=O)₂-, -NR²-, -O-, or -S-, and where one or more hydrogen atoms may be replaced by deuterium, F, Cl, Br, I, CN, CF₃ or NO₂ or an aromatic or heteroaromatic ring system having 5 to 60 aromatic ring atoms, each of which may be substituted by one or more R² moieties, or an aryloxy or heteroaryloxy group having 5 to 60 aromatic ring atoms, which may be substituted by one or more R⁹ moieties, or a diarylamino group, diheteroarylamino group or arylheteroarylamino group having 10 to 40 aromatic ring atoms, which may be substituted by one or more R⁹ moieties, or a combination of these systems; at the same time two or more of these R substituents together may also form a monocyclic, aliphatic, ring system having in total five or six ring members;
R² is at each instance independently of each other selected from the group consistent of H, deuterium, phenyl, naphthyl, CF₃, C(=O)OR³, Si(R⁴)₃, C(=O)R³, P(=O)(R⁷)₂, As(=O)(R⁷)₂ P(=S)(R⁷)₂, As(=S)(R⁷)₂, S(=O)R³, S(=O)₂R³, a linear alkyl, alkoxy or thioalkoxy group having 1 to 40 carbon atoms or a linear alkenyl or alkynyl group having 2 to 40 carbon atoms or a branched or cyclic alkyl, alkenyl, alkynyl, alkoxy or thioalkoxy group having 3 to 40 carbon atoms, each of which may be substituted by one or more R⁹ moieties, where one or more adjacent CH₂ groups may be replaced by -R⁹C=CR⁹-, -C=C- and one adjacent CH₂ group may be replaced by -Si(R⁴)₂-, - Ge(R⁴)₂-, -Sn(R⁴)₂, -C(=O)-, -C(=S)-, -C(=Se)-, -C=N-, -C(=O)O-, -C(=O)N(R³)-, - P(=O)(R⁷)-, -As(=O)(R⁷)-, -P(=S)(R⁷)-, -As(=S)(R⁷)-, -S(=O)-, -S(=O)₂-, -O-, or -S-, and where one or more hydrogen atoms may be replaced by deuterium, F, Cl, Br, I, CN, CF₃ or NO₂ or an aromatic or heteroaromatic ring system having 5 to 60 aromatic ring atoms, each of which may be substituted by one or more R⁹ moieties, or an aryloxy or heteroaryloxy group having 5 to 60 aromatic ring atoms, which may be substituted by one or more R⁹ moieties, or a diarylamino group, diheteroarylamino group or arylheteroarylamino group having 10 to 40 aromatic ring atoms, which may be substituted by one or more R⁹ moieties, or a combination of these systems;
at the same time two or more of these R² substituents together may also form a mono- or polycyclic, aliphatic, aromatic and/or benzo-fused ring system;
R³ is at each instance independently of each other selected from the group consistent of H, deuterium, phenyl, naphthyl, CF₃ or an aliphatic, aromatic and/or heteroaromatic hydrocarbonyl moiety having 1 to 20 carbon atoms, in which one or more hydrogen atoms may be replaced by F or CF₃; at the same time, two or more R³ substituents together may also form a mono- or polycyclic aliphatic ring system;
R⁴ is at each instance independently of each other selected from the group consistent of H, deuterium, phenyl, naphthyl, CN, CF₃, OH, C(=O)OR³, C(=O)N(R³)₂, C(=O)R³, P(=O)(R⁷)₂, As(=O)(R⁷)₂, P(=S)(R⁷)₂, As(=S)(R⁷)₂, a linear alkyl, alkoxy or thioalkoxy group having 1 to 40 carbon atoms or a linear alkenyl or alkynyl group having 2 to 40 carbon atoms or a branched or cyclic alkyl, alkenyl, alkynyl, alkoxy or thioalkoxy group having 3 to 40 carbon atoms, each of which may be substituted by one or more R⁹ moieties, where one or more adjacent CH₂ groups may be replaced by -R⁹C=CR⁹-, - C=C- and one adjacent CH₂ group may be replaced by -C(=O)-, -C(=S)-, -C(=Se)-, - C=N-, -C(=O)O-, -C(=O)N(R³)-, -P(=O)(R⁷)-, -As(=O)(R⁷)-, -P(=S)(R⁷)-, -As(=S)(R⁷)-, - S(=O)-, -S(=O)₂-, -O-, or -S-, and where one or more hydrogen atoms may be replaced by deuterium, F, Cl, Br, I, CN, CF₃ or NO₂ or an aromatic or heteroaromatic ring system having 5 to 60 aromatic ring atoms, each of which may be substituted by one or more R⁸ moieties, or an aryloxy or heteroaryloxy group having 5 to 60 aromatic ring atoms, which may be substituted by one or more R⁹ moieties, or a diarylamino group, diheteroarylamino group or arylheteroarylamino group having 10 to 40 aromatic ring atoms, which may be substituted by one or more R⁹ moieties, or a combination of these systems; at the same time two or more of these R⁴ substituents together may also form a mono- or polycyclic, aliphatic, aromatic and/or benzo-fused ring system;
R⁵ is at each instance independently of each other selected from the group consistent of phenyl, naphthyl, CF₃, C(=O)R³, P(=O)(R⁷)₂, As(=O)(R⁷)₂, a linear alkyl, alkoxy or thioalkoxy group having 1 to 40 carbon atoms or a linear alkenyl or alkynyl group having 2 to 40 carbon atoms or a branched or cyclic alkyl, alkenyl, alkynyl, alkoxy or thioalkoxy group having 3 to 40 carbon atoms, each of which may be substituted by one or more R⁹ moieties, where one or more adjacent CH₂ groups may be replaced by -R⁹C=CR⁹-, -C=C- and one adjacent CH₂ group may be replaced by -Si(R⁴)₂-, - Ge(R⁴)₂-, -Sn(R⁴)₂, -C(=O)-, -C(=S)-, -C(=Se)-, -C=N-, -C(=O)O-, -C(=O)N(R³)-, - P(=O)(R⁷)-, -As(=O)(R⁷)-, -P(=S)(R⁷)-, -As(=S)(R⁷)-, -S(=O)-, -S(=O)₂-, -NR²-, -O-, or - S-, and where one or more hydrogen atoms may be replaced by deuterium, F, Cl, Br, I, CN, CF₃ or NO₂ or an aromatic or heteroaromatic ring system having 5 to 60 aromatic ring atoms, each of which may be substituted by one or more R⁹ moieties, or an aryloxy or heteroaryloxy group having 5 to 60 aromatic ring atoms, which may be substituted by one or more R⁹ moieties, or a diarylamino group, diheteroarylamino group or arylheteroarylamino group having 10 to 40 aromatic ring atoms, which may be substituted by one or more R⁹ moieties, or a combination of these systems; at the same time two or more of these R⁵ substituents together may also form a mono- or polycyclic, aliphatic, aromatic and/or benzo-fused ring system;
R⁶ is at each instance independently of each other selected from the group consistent of phenyl, naphthyl, CF₃, Si(R⁴)₃, C(=O)R³, P(=O)(R⁷)₂, a linear alkyl, alkoxy or thioalkoxy group having 1 to 40 carbon atoms or a linear alkenyl or alkynyl group having 2 to 40 carbon atoms or a branched or cyclic alkyl, alkenyl, alkynyl, alkoxy or thioalkoxy group having 3 to 40 carbon atoms, each of which may be substituted by one or more R⁹ moieties, where one or more adjacent CH₂ groups may be replaced by -R⁹C=CR⁹-, -C=C- and one adjacent CH₂ group may be replaced by -Si(R⁴)₂-, - Ge(R⁴)₂-, -Sn(R⁴)₂, -C(=O)-, -C(=S)-, -C(=Se)-, -C=N-, -C(=O)O-, -C(=O)N(R³)-, - P(=O)(R⁷)-, -As(=O)(R⁷)-, -P(=S)(R⁷)-, -As(=S)(R⁷)-, -S(=O)-, -S(=O)₂-, -NR²-, -O-, or - S-, and where one or more hydrogen atoms may be replaced by deuterium, F, Cl, Br, I, CN, CF₃ or NO₂ or an aromatic or heteroaromatic ring system having 5 to 60 aromatic ring atoms, each of which may be substituted by one or more R⁹ moieties, or an aryloxy or heteroaryloxy group having 5 to 60 aromatic ring atoms, which may be substituted by one or more R moieties, or a diarylamino group, diheteroarylamino group or arylheteroarylamino group having 10 to 40 aromatic ring atoms, which may be substituted by one or more R⁹ moieties, or a combination of these systems; at the same time two or more of these R⁶ substituents together may also form a mono- or polycyclic, aliphatic, aromatic and/or benzo-fused ring system;
R⁷ is at each instance independently of each other selected from the group consistent of phenyl, naphthyl, CN, CF₃, C(=O)OR³, C(=O)N(R³)₂, C(=O)R³, a linear alkyl, alkoxy or thioalkoxy group having 1 to 40 carbon atoms or a linear alkenyl or alkynyl group having 2 to 40 carbon atoms or a branched or cyclic alkyl, alkenyl, alkynyl, alkoxy or thioalkoxy group having 3 to 40 carbon atoms, each of which may be substituted by one or more R⁹ moieties, where one or more adjacent CH₂ groups may be replaced by -R⁹C=CR⁹-, -C=C- and one adjacent CH₂ group may be replaced by -C(=O)-, -C(=S)-, -C(=Se)-, -C=N-, -C(=O)O-, -C(=O)N(R³)-, -S(=O)-, -S(=O)₂-, -O-, or -S-, and where one or more hydrogen atoms may be replaced by deuterium, F, Cl, Br, I, CN, CF₃ or NO₂ or an aromatic or heteroaromatic ring system having 5 to 60 aromatic ring atoms, each of which may be substituted by one or more R⁹ moieties, or an aryloxy or heteroaryloxy group having 5 to 60 aromatic ring atoms, which may be substituted by one or more R⁹ moieties, or a diarylamino group, diheteroarylamino group or arylheteroarylamino group having 10 to 40 aromatic ring atoms, which may be substituted by one or more R³ moieties, or a combination of these systems; at the same time two or more of these R⁷ substituents together may also form a mono- or polycyclic, aliphatic, aromatic and/or benzo-fused ring system;
R⁸ is at each instance independently of each other selected from the group consistent of H, deuterium, phenyl, naphthyl, F, CF₃ or an aliphatic, aromatic and/or heteroaromatic hydrocarbonyl moiety having 1 to 20 carbon atoms, in which one or more hydrogen atoms may be replaced by F or CF₃; at the same time, two or more R⁸ substituents together may also form a mono- or polycyclic aliphatic ring system;
R⁹ is at each instance independently of each other selected from the group consistent of H, deuterium, phenyl, naphthyl, CN, CF₃, NO₂, OH, COOH, C(=O)OR³, C(=O)N(R³)₂, C(=O)R³, S(=O)R³, S(=O)₂R³, OSO₂R³, a linear alkyl, alkoxy or thioalkoxy group having 1 to 40 carbon atoms or a linear alkenyl or alkynyl group having 2 to 40 carbon atoms or a branched or cyclic alkyl, alkenyl, alkynyl, alkoxy or thioalkoxy group having 3 to 40 carbon atoms, each of which may be substituted by one or more R⁸ moieties, where one or more adjacent CH₂ groups may be replaced by -R⁹C=CR⁹-, -C=C- and one adjacent CH₂ group may be replaced by -C(=O)-, -C(=S)-, -C(=Se)-, -C=N-, - C(=O)O-, -C(=O)N(R³)-, -S(=O)-, -S(=O)₂-, -O-, or -S-, and where one or more hydrogen atoms may be replaced by deuterium, F, Cl, Br, I, CN, CF₃ or NO₂ or an aromatic or heteroaromatic ring system having 5 to 60 aromatic ring atoms, each of which may be substituted by one or more R⁸ moieties, or an aryloxy or heteroaryloxy group having 5 to 60 aromatic ring atoms, which may be substituted by one or more R³ moieties, or a diarylamino group, diheteroarylamino group or arylheteroarylamino group having 10 to 40 aromatic ring atoms, which may be substituted by one or more R⁸ moieties, or a combination of these systems; at the same time two or more of these R⁹ substituents together may also form a mono- or polycyclic, aliphatic, aromatic and/or benzo-fused ring system.

2. Use of a metal complex according to claim 1 as an emitter or an absorber and/or a matrix material and/or a hole blocking material and/or as an electron transport material in an optoelectronic component.

3. The use according to claim 2, wherein the optoelectronic component is selected from the group consisting of:
- organic electroluminescent components (organic light diodes, OLEDs, PLEDs),
- organic integrated circuits (O-ICs),
- light emitting electrochemical cells (LECs),
- organic solar cells (O-SCs),
- organic field effect transistors (O-FETs),
- organic thin film transistors (O-TFTs),
- organic light emitting transistors (O-LETs),
- OLED-sensors, in particular gas and vapor sensors not hermetically sealed to the outside,
- organic optical detectors,
- organic photoreceptors,
- organic field quench devices (O-FQDs) and
- organic laser diodes (O-Laser).

4. The use according to claim 2 or 3, **characterized in that** the fraction of the metal complex in the emitter or absorber is 100%.

5. The use according to claim 2 or 3, **characterized in that** the fraction of the metal complex in the emitter or absorber is 1 to 99% by weight, preferably 2 to 90% by weight, more preferred 3 to 40% by weight, in particular 5 to 15% by weight in relation to the total mixture of emitter and matrix material.

6. The use according to claim 2 or 3, **characterized in that** the fraction of the metal complex in the matrix material is 99 to 1% by weight, preferably 98 to 10 % by weight, more preferred 97 to 60% by weight, in particular 95 to 85 % by weight in relation to the total mixture of emitter and matrix material.

7. Optoelectronic component, comprising a metal complex according to claim 1.

8. The optoelectronic component according to claim 7, formed as a component selected from the group consisting of organic electroluminescent compound, organic integrated circuit, light-emitting electrochemical cell, organic solar cell, organic field effect transistor, organic thin film transistor, organic light emitting transistors, OLED-sensors, in particular in gas and vapor sensors not hermetically sealed off to the outside, organic optical detectors, organic photoreceptors, organic field quench devices and organic laser diodes.

9. Method for producing an optoelectronic component, wherein the metal complex according to claim 1 is used.

10. The method according to claim 9, **characterized in that** a metal complex according to claim 1 is deposited on a carrier.

11. The method according to claim 8, **characterized in that** the deposition is carried out using wet-chemical means by colloidal suspension or by sublimation.

12. The method according to claim 10 or 11, wherein one or more layers are coated with a sublimation process and wherein the materials are vapor-deposited in a vacuum deposition device at a pressure smaller than 10⁻⁵ mbar, preferred smaller than 10⁻⁶ mbar, more preferred smaller than 10⁻⁷ mbar.

## Revendications

1. Complexe métallique, comprenant une structure de formule A-3 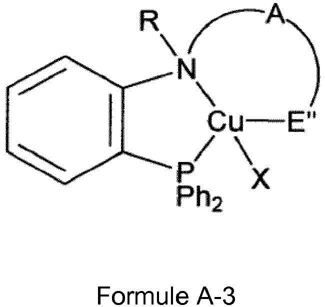 dans laquelle
A = un pont contenant plus d'un et moins de six (relatif à la longueur de chaîne la plus courte) chaînons k identiques ou différents, de préférence plus d'un et moins de 4, de manière davantage préférée plus d'un et moins de 3, avec k = C(sp²)R, CR₂, C=O, C=S, C=NR, O, N, NR, S, Se ; un ou plusieurs chaînons k étant éventuellement également définis comme une partie d'un système cyclique aromatique ou aliphatique, tels que C(sp²) ;
E" = un groupe chimiquement neutre choisi parmi C*R (carbone de carbène), NR (azote d'imine), NR₂, PR₂, AsR₂, OR, SR, SeR, éventuellement défini en tant que partie d'un système cyclique aromatique ou hétéroaromatique neutre, tel que C(sp²), ou un groupe chargé négativement une fois choisi parmi NR, PR, AsR, O, S, Se, éventuellement défini en tant que partie d'un système cyclique hétéroaromatique anionique, tel que C(sp²) ;
X = choisi dans le groupe constitué par Cl, Br, I, CN, OCN, SCN, alcynyle et N₃; X étant seulement présent lorsque E" = un groupe chimiquement neutre ;
les R sont choisis indépendamment les uns des autres à chaque occurrence dans le groupe constitué par H, deutérium, phényle, naphtyle, F, Cl, Br, I, N(R²)₂, -CN, -NC, - SCN, -CF₃, -NO₂, -OH, C(=O)OH, C(=O)OR³, C(=O)N(R³)₂, C(=O)SR³, C(=S)SR³, Si(R⁴)₃, B(OR⁵)₂, B(N(R⁶)₂)₂, C(=O)R³, P(=O)(R⁷)₂, As(=O)(R⁷)₂, P(=S)(R⁷)₂, As(=S)(R⁷)₂, S(=O)R³, S=NR³, S(=O)NR³, S(=O)₂NR³, S(=O)₂R³, O-S(=O)₂R³, SF₅, un groupe alkyle, alcoxy ou thioalcoxy linéaire de 1 à 40 atomes C ou un groupe alcényle ou alcynyle linéaire de 2 à 40 atomes C ou un groupe alkyle, alcényle, alcynyle, alcoxy ou thioalcoxy ramifié ou cyclique de 3 à 40 atomes C, qui peut à chaque fois être substitué avec un ou plusieurs radicaux R⁹, un ou plusieurs groupes CH₂ voisins pouvant être remplacés par -R⁹C=CR⁹-, -C=C-, ou un groupe CH₂ voisin pouvant être remplacé par -Si(R⁴)₂-, -Ge(R⁴)₂-, -Sn(R⁴)₂, -C(=O)-, -C(=S)-, -C(=Se)-, -C=N-, -C(=O)O-, -C(=O)N(R³)-, -P(=O)(R⁷)-, -As(=O)(R⁷)-, -P(=S)(R⁷)-, -As(=S)(R⁷)-, -S(=O)-, -S(=O)₂-, -NR²-, -O- ou -S-, et un ou plusieurs atomes H pouvant être remplacés par deutérium, F, Cl, Br, I, CN, CF₃ ou NO₂, ou un système cyclique aromatique ou hétéroaromatique de 5 à 60 atomes de cycle aromatique, qui peut à chaque fois être substitué par un ou plusieurs radicaux R², ou un groupe aryloxy ou hétéroaryloxy de 5 à 60 atomes de cycle aromatique, qui peut être substitué par un ou plusieurs radicaux R⁹, ou un groupe diarylamino, un groupe dihétéroarylamino ou un groupe arylhétéroarylamino de 10 à 40 atomes de cycle aromatique, qui peut être substitué par un ou plusieurs radicaux R⁹, ou une combinaison de ces systèmes; deux ou plus de ces substituants R pouvant également former les uns avec les autres un système cyclique aliphatique monocyclique contenant au total cinq ou six chaînons ;
les R² sont choisis indépendamment les uns des autres à chaque occurrence dans le groupe constitué par H, deutérium, phényle, naphtyle, CF₃, C(=O)OR³, Si(R⁴)₃, C(=O)R³, P(=O)(R⁷)₂, As(=O)(R⁷)₂, P(=S)(R⁷)₂, As(=S)(R⁷)₂, S(=O)R³ S(=O)₂R³, un groupe alkyle, alcoxy ou thioalcoxy linéaire de 1 à 40 atomes C ou un groupe alcényle ou alcynyle linéaire de 2 à 40 atomes C ou un groupe alkyle, alcényle, alcynyle, alcoxy ou thioalcoxy ramifié ou cyclique de 3 à 40 atomes C, qui peut à chaque fois être substitué avec un ou plusieurs radicaux R⁹, un ou plusieurs groupes CH₂ voisins pouvant être remplacés par -R⁹C=CR⁹-, -C=C-, ou un groupe CH₂ voisin pouvant être remplacé par -Si(R⁴)₂-, -Ge(R⁴)₂-, -Sn(R⁴)₂, -C(=O)-, -C(=S)-, -C(=Se)-, -C=N-, -C(=O)O-, -C(=O)N(R³)-, -P(=O)(R⁷)-, -As(=O)(R⁷)-, -P(=S)(R⁷)-, -As(=S)(R⁷)-, -S(=O)-, -S(=O)₂-, -O- ou -S-, et un ou plusieurs atomes H pouvant être remplacés par deutérium, F, Cl, Br, I, CN, CF₃ ou NO₂, ou un système cyclique aromatique ou hétéroaromatique de 5 à 60 atomes de cycle aromatique, qui peut à chaque fois être substitué par un ou plusieurs radicaux R⁹, ou un groupe aryloxy ou hétéroaryloxy de 5 à 60 atomes de cycle aromatique, qui peut être substitué par un ou plusieurs radicaux R⁹, ou un groupe diarylamino, un groupe dihétéroarylamino ou un groupe arylhétéroarylamino de 10 à 40 atomes de cycle aromatique, qui peut être substitué par un ou plusieurs radicaux R⁹, ou une combinaison de ces systèmes ; deux ou plus de ces substituants R² pouvant également former les uns avec les autres un système cyclique aliphatique, aromatique et/ou benzoannelé mono- ou polycyclique ;
les R³ sont choisis indépendamment les uns des autres à chaque occurrence dans le groupe constitué par H, deutérium, phényle, naphtyle, CF₃ ou un radical hydrocarboné aliphatique, aromatique et/ou hétéroaromatique de 1 à 20 atomes C, dans lequel un ou plusieurs atomes H peuvent également être remplacés par F ou CF₃ ; deux ou plus de ces substituants R³ pouvant également former les uns avec les autres un système cyclique aliphatique, mono- ou polycyclique ;
les R⁴ sont choisis indépendamment les uns des autres à chaque occurrence dans le groupe constitué par H, deutérium, phényle, naphtyle, CN, CF₃, OH, C(=O)OR³ C(=O)N(R³)₂, C(=O)R³, P(=O)(R⁷)₂, As(=O)(R⁷)₂, P(=S)(R⁷)₂, As(=S)(R⁷)₂, un groupe alkyle, alcoxy ou thioalcoxy linéaire de 1 à 40 atomes C ou un groupe alcényle ou alcynyle linéaire de 2 à 40 atomes C ou un groupe alkyle, alcényle, alcynyle, alcoxy ou thioalcoxy ramifié ou cyclique de 3 à 40 atomes C, qui peut à chaque fois être substitué avec un ou plusieurs radicaux R⁹, un ou plusieurs groupes CH₂ voisins pouvant être remplacés par -R⁹C=CR⁹-, -C=C-, ou un groupe CH₂ voisin pouvant être remplacé par -C(=O)-, -C(=S)-, -C(=Se)-, -C=N-, -C(=O)O-, -C(=O)N(R³)-, -P(=O)(R⁷)-, -As(=O)(R⁷)-, -P(=S)(R⁷)-, -As(=S)(R⁷)-, -S(=O)-, -S(=O)₂-, -O- ou -S-, et un ou plusieurs atomes H pouvant être remplacés par deutérium, F, Cl, Br, I, CN, CF₃ ou NO₂, ou un système cyclique aromatique ou hétéroaromatique de 5 à 60 atomes de cycle aromatique, qui peut à chaque fois être substitué par un ou plusieurs radicaux R⁸, ou un groupe aryloxy ou hétéroaryloxy de 5 à 60 atomes de cycle aromatique, qui peut être substitué par un ou plusieurs radicaux R⁹, ou un groupe diarylamino, un groupe dihétéroarylamino ou un groupe arylhétéroarylamino de 10 à 40 atomes de cycle aromatique, qui peut être substitué par un ou plusieurs radicaux R⁹, ou une combinaison de ces systèmes ; deux ou plus de ces substituants R⁴ pouvant également former les uns avec les autres un système cyclique aliphatique, aromatique et/ou benzoannelé mono- ou polycyclique ;
les R⁵ sont choisis indépendamment les uns des autres à chaque occurrence dans le groupe constitué par phényle, naphtyle, CF₃, C(=O)R³, P(=O)(R⁷)₂, As(=O)(R⁷)₂, un groupe alkyle, alcoxy ou thioalcoxy linéaire de 1 à 40 atomes C ou un groupe alcényle ou alcynyle linéaire de 2 à 40 atomes C ou un groupe alkyle, alcényle, alcynyle, alcoxy ou thioalcoxy ramifié ou cyclique de 3 à 40 atomes C, qui peut à chaque fois être substitué avec un ou plusieurs radicaux R⁹, un ou plusieurs groupes CH₂ voisins pouvant être remplacés par -R⁹C=CR⁹-, -C=C-, ou un groupe CH₂ voisin pouvant être remplacé par -Si(R⁴)₂-, -Ge(R⁴)₂-, -Sn(R⁴)₂, -C(=O)-, -C(=S)-, -C(=Se)-, -C=N-, -C(=O)O-, -C(=O)N(R³)-, -P(=O)(R⁷)-, -As(=O)(R⁷)-, -P(=S)(R⁷)-, -As(=S)(R⁷)-, -S(=O)-, -S(=O)₂-, -NR²-, -O- ou -S-, et un ou plusieurs atomes H pouvant être remplacés par deutérium, F, Cl, Br, I, CN, CF₃ ou NO₂, ou un système cyclique aromatique ou hétéroaromatique de 5 à 60 atomes de cycle aromatique, qui peut à chaque fois être substitué par un ou plusieurs radicaux R⁹, ou un groupe aryloxy ou hétéroaryloxy de 5 à 60 atomes de cycle aromatique, qui peut être substitué par un ou plusieurs radicaux R⁹, ou un groupe diarylamino, un groupe dihétéroarylamino ou un groupe arylhétéroarylamino de 10 à 40 atomes de cycle aromatique, qui peut être substitué par un ou plusieurs radicaux R⁹, ou une combinaison de ces systèmes ; deux ou plus de ces substituants R⁵ pouvant également former les uns avec les autres un système cyclique aliphatique, aromatique et/ou benzoannelé mono- ou polycyclique ;
les R⁶ sont choisis indépendamment les uns des autres à chaque occurrence dans le groupe constitué par phényle, naphtyle, CF₃, Si(R⁴)₃, C(=O)R³, P(=O)(R⁷)₂, un groupe alkyle, alcoxy ou thioalcoxy linéaire de 1 à 40 atomes C ou un groupe alcényle ou alcynyle linéaire de 2 à 40 atomes C ou un groupe alkyle, alcényle, alcynyle, alcoxy ou thioalcoxy ramifié ou cyclique de 3 à 40 atomes C, qui peut à chaque fois être substitué avec un ou plusieurs radicaux R⁹, un ou plusieurs groupes CH₂ voisins pouvant être remplacés par -R⁹C=CR⁹-, -C=C-, ou un groupe CH₂ voisin pouvant être remplacé par -Si(R⁴)₂-, -Ge(R⁴)₂-, -Sn(R⁴)₂, -C(=O)-, -C(=S)-, -C(=Se)-, -C=N-, -C(=O)O-, -C(=O)N(R³)-, -P(=O)(R⁷)-, -As(=O)(R⁷)-, -P(=S)(R⁷)-, -As(=S)(R⁷)-, -S(=O)-, -S(=O)₂-, -NR²-, -O- ou -S-, et un ou plusieurs atomes H pouvant être remplacés par deutérium, F, Cl, Br, I, CN, CF₃ ou NO₂, ou un système cyclique aromatique ou hétéroaromatique de 5 à 60 atomes de cycle aromatique, qui peut à chaque fois être substitué par un ou plusieurs radicaux R⁹, ou un groupe aryloxy ou hétéroaryloxy de 5 à 60 atomes de cycle aromatique, qui peut être substitué par un ou plusieurs radicaux R, ou un groupe diarylamino, un groupe dihétéroarylamino ou un groupe arylhétéroarylamino de 10 à 40 atomes de cycle aromatique, qui peut être substitué par un ou plusieurs radicaux R⁹, ou une combinaison de ces systèmes ; deux ou plus de ces substituants R⁶ pouvant également former les uns avec les autres un système cyclique aliphatique, aromatique et/ou benzoannelé mono- ou polycyclique ;
les R⁷ sont choisis indépendamment les uns des autres à chaque occurrence dans le groupe constitué par phényle, naphtyle, CN, CF₃, C(=O)OR³, C(=O)N(R³)₂, C(=O)R³, un groupe alkyle, alcoxy ou thioalcoxy linéaire de 1 à 40 atomes C ou un groupe alcényle ou alcynyle linéaire de 2 à 40 atomes C ou un groupe alkyle, alcényle, alcynyle, alcoxy ou thioalcoxy ramifié ou cyclique de 3 à 40 atomes C, qui peut à chaque fois être substitué avec un ou plusieurs radicaux R⁹, un ou plusieurs groupes CH₂ voisins pouvant être remplacés par -R⁹C=CR⁹-, -C=C-, ou un groupe CH₂ voisin pouvant être remplacé par -C(=O)-, -C(=S)-, -C(=Se)-, -C=N-, -C(=O)O-, -C(=O)N(R³)-, -S(=O)-, -S(=O)₂-, -O- ou -S-, et un ou plusieurs atomes H pouvant être remplacés par deutérium, F, Cl, Br, I, CN, CF₃ ou NO₂, ou un système cyclique aromatique ou hétéroaromatique de 5 à 60 atomes de cycle aromatique, qui peut à chaque fois être substitué par un ou plusieurs radicaux R⁹, ou un groupe aryloxy ou hétéroaryloxy de 5 à 60 atomes de cycle aromatique, qui peut être substitué par un ou plusieurs radicaux R⁹, ou un groupe diarylamino, un groupe dihétéroarylamino ou un groupe arylhétéroarylamino de 10 à 40 atomes de cycle aromatique, qui peut être substitué par un ou plusieurs radicaux R³, ou une combinaison de ces systèmes ; deux ou plus de ces substituants R⁷ pouvant également former les uns avec les autres un système cyclique aliphatique, aromatique et/ou benzoannelé mono- ou polycyclique ;
les R⁸ sont choisis indépendamment les uns des autres à chaque occurrence dans le groupe constitué par H, deutérium, phényle, naphtyle, F, CF₃ ou un radical hydrocarboné aliphatique, aromatique et/ou hétéroaromatique de 1 à 20 atomes C, dans lequel un ou plusieurs atomes H peuvent également être remplacés par F ou CF₃ ; deux ou plus de ces substituants R⁸ pouvant également former les uns avec les autres un système cyclique aliphatique mono- ou polycyclique ;
les R⁹ sont choisis indépendamment les uns des autres à chaque occurrence dans le groupe constitué par H, deutérium, phényle, naphtyle, CN, CF₃, NO₂, OH, COOH, C(=O)OR³, C(=O)N(R³)₂, C(=O)R³, S(=O)R³, S(=O)₂R³, OSO₂R³, un groupe alkyle, alcoxy ou thioalcoxy linéaire de 1 à 40 atomes C ou un groupe alcényle ou alcynyle linéaire de 2 à 40 atomes C ou un groupe alkyle, alcényle, alcynyle, alcoxy ou thioalcoxy ramifié ou cyclique de 3 à 40 atomes C, qui peut à chaque fois être substitué avec un ou plusieurs radicaux R⁸, un ou plusieurs groupes CH₂ voisins pouvant être remplacés par -R³C=CR³-, -C=C-, ou un groupe CH₂ voisin pouvant être remplacé par -C(=O)-, -C(=S)-, -C(=Se)-, -C=N-, -C(=O)O-, -C(=O)N(R³)-, -S(=O)-, -S(=O)₂-, -O- ou -S-, et un ou plusieurs atomes H pouvant être remplacés par deutérium, F, Cl, Br, I, CN, CF₃ ou NO₂, ou un système cyclique aromatique ou hétéroaromatique de 5 à 60 atomes de cycle aromatique, qui peut à chaque fois être substitué par un ou plusieurs radicaux R⁸, ou un groupe aryloxy ou hétéroaryloxy de 5 à 60 atomes de cycle aromatique, qui peut être substitué par un ou plusieurs radicaux R³, ou un groupe diarylamino, un groupe dihétéroarylamino ou un groupe arylhétéroarylamino de 10 à 40 atomes de cycle aromatique, qui peut être substitué par un ou plusieurs radicaux R⁸, ou une combinaison de ces systèmes ; deux ou plus de ces substituants R⁹ pouvant également former les uns avec les autres un système cyclique aliphatique, aromatique et/ou benzoannelé mono- ou polycyclique.

2. Utilisation d'un complexe métallique selon la revendication 1 en tant qu'émetteur ou absorbeur et/ou matériau de matrice et/ou matériau de blocage de trous et/ou en tant que matériau de transport d'électrons dans un composant optoélectronique.

3. Utilisation selon la revendication 2, dans laquelle le composant optoélectronique est choisi dans le groupe constitué par :
- les dispositifs électroluminescents organiques (diodes luminescentes organiques, OLED, PLED),
- les circuits intégrés organiques (O-IC),
- les cellules électrochimiques électroluminescentes (LEC),
- les cellules solaires organiques (O-SC),
- les transistors à effet de champ organiques (O-FET),
- les transistors à film mince organique (O-TFT),
- les transistors électroluminescents organiques (O-LET),
- les capteurs OLED, notamment dans des capteurs de gaz et de vapeur non blindés hermétiquement vers l'extérieur,
- les détecteurs optiques organiques,
- les photorécepteurs organiques,
- les dispositifs d'extinction de champ organiques (O-FQD) et
- les diodes lasers organiques (O-laser).

4. Utilisation selon la revendication 2 ou 3, **caractérisée en ce que** la proportion du complexe métallique dans l'émetteur ou l'absorbeur est de 100 %.

5. Utilisation selon la revendication 2 ou 3, **caractérisée en ce que** la proportion du complexe métallique dans l'émetteur ou l'absorbeur est de 1 à 99 % en poids, de préférence de 2 à 90 % en poids, de manière particulièrement préférée de 3 à 40 % en poids, notamment de 5 à 15 % en poids, par rapport au mélange total d'émetteur et de matériau de matrice.

6. Utilisation selon la revendication 2 ou 3, **caractérisée en ce que** la proportion du complexe métallique dans le matériau de matrice est de 99 à 1 % en poids, de préférence de 98 à 10 % en poids, de manière particulièrement préférée de 97 à 60 % en poids, notamment de 95 à 85 % en poids, par rapport au mélange total de l'émetteur et du matériau de matrice.

7. Composant optoélectronique, comprenant un complexe métallique selon la revendication 1.

8. Composant optoélectronique selon la revendication 7, configuré sous la forme d'un composant choisi dans le groupe constitué par un dispositif électroluminescent organique, un circuit intégré organique, une cellule électrochimique électroluminescente, une cellule solaire organique, un transistor à effet de champ organique, un transistor à film mince organique, les transistors électroluminescents organiques, les capteurs OLED, notamment dans des capteurs de gaz et de vapeur non blindés hermétiquement vers l'extérieur, les détecteurs optiques organiques, les photorécepteurs organiques, les dispositifs d'extinction de champ organiques et les diodes lasers organiques.

9. Procédé de fabrication d'un composant optoélectronique, selon lequel un complexe métallique selon la revendication 1 est utilisé.

10. Procédé selon la revendication 9, **caractérisé par** l'application d'un complexe métallique selon la revendication 1 sur un support.

11. Procédé selon la revendication 8, **caractérisé en ce que** l'application a lieu par voie chimique humide, au moyen d'une suspension colloïdale ou au moyen d'une sublimation.

12. Procédé selon la revendication 10 ou 11, selon lequel une ou plusieurs couches sont revêtues avec un procédé de sublimation et les matériaux sont évaporés dans des unités de sublimation sous vide à une pression inférieure à 10⁻⁵ mbar, de préférence inférieure à 10⁻⁶ mbar, de manière particulièrement préférée inférieure à 10⁻⁷ mbar.
